# EUROPÄISCHE PATENTSCHRIFT

(11) **EP 2 614 694 B1**
(45) Veröffentlichungstag und Bekanntmachung des Hinweises auf die Patenterteilung: **26.02.2020**
(21) Anmeldenummer: 11763584.7
(22) Anmeldetag: 29.08.2011
(51) Int. Cl.: F21K 9/00, F21K 9/90, H01L 21/56, H01L 25/13, H01L 31/0203, H01L 31/0232, H01L 33/56, H01L 23/31, H01L 25/075, H01L 33/50, H01L 33/54, H01L 33/58, H01L 33/60, H05K 3/28, F21Y 115/10

(54) **BESCHICHTUNGSVERFAHREN FÜR EIN OPTOELEKTRONISCHES CHIP-ON-BOARD-MODUL**
COATING METHOD FOR AN OPTOELECTRONIC CHIP-ON-BOARD MODULE
PROCÉDÉ POUR RECOUVRIR UN MODULE PUCE-SUR-PLAQUE OPTOÉLECTRONIQUE D'UN REVÊTEMENT

(30) Priorität: 18.07.2011 DE 102011107892; 06.09.2010 DE 102010044471
(43) Veröffentlichungstag der Anmeldung: 17.07.2013
(73) Patentinhaber: Heraeus Noblelight GmbH, 63450 Hanau (DE)
(72) Erfinder: PEIL, Michael, 64853 Otzberg (DE); OSWALD, Florin, 60329 Frankfurt am Main (DE); MAIWEG, Harald, 41352 Korschenbroich (DE)
(74) Vertreter: Heraeus IP
(86) Internationale Anmeldenummer: PCT/EP2011/004326
(87) Internationale Veröffentlichungsnummer: WO 2012/031703

(56) Entgegenhaltungen:
- WO-A1-2008/152575
- DE-A1-102008 009 808
- JP-A- 2009 111 102
- US-A- 4 897 027
- US-A- 5 797 207
- US-A1- 2008 112 162

## Beschreibung

Die Erfindung betrifft ein Verfahren zur Beschichtung eines optoelektronischen Chip-On-Board-Moduls, das einen flächigen Träger umfasst, der mit einem oder mehreren optoelektronischen Komponenten bestückt ist, mit einer transparenten, UV- und temperaturbeständigen Beschichtung aus einem Silikon, ein entsprechendes optoelektronisches Chip-On-Board-Modul und ein System mit mehreren optoelektronischen Chip-On-Board-Modulen.

Gattungsgemäße optoelektronische Chip-On-Board-Module werden beispielsweise als Leuchtkörper, als Hochleistungs-UV-LED-Lampen, als Photovoltaik-Module, Sensoren o. ä. verwendet. Bei den dabei verwendeten optoelektronischen Komponenten handelt es sich im Rahmen der Erfindung beispielsweise, aber nicht ausschließlich, um LEDs oder Photodioden in Form von Chips oder anderen Bauteilen, die im Chip-On-Board-Modul auf einem flächigen Träger, also einem Metall-, Keramik- oder Siliziumsubstrat, einer Metallkern- oder FR4-Leiterplatte, einem Glasträger, einem Kunststoffträger o. ä. angeordnet sind. Diese Chip-On-Board-Module müssen vor mechanischen Schäden und Korrosion geschützt werden. Hierzu werden möglichst kompakte und leichte Lösungen gesucht.

Aus dem Stand der Technik sind Leuchtdioden-Module mit einem Leuchtdioden-Array und einem Mikrolinsen-Array in verschiedenen Ausgestaltungen bekannt. Beispiele derartiger Leuchtdioden-Module sowie Verfahren zu deren Herstellung sind exemplarisch in US 7,638,808 B2, in US 20100065983 A1, in US 20070045761 A1 oder in US 7,819,550 B2 beschrieben. Auch in der nachveröffentlichten deutschen Patentanmeldung mit der Nummer DE 10 2010 044 470 wird ein Verfahren zur Herstellung eines Mikrolinsen-Arrays für ein optoelektronisches Modul beschrieben.

Ein Schutz in der Form von Gehäusen auf Chip-On-Board-Modulen ist oft kostenaufwändig und technologisch aufwändig. Eine praktikable Alternative zum Schutz von Chip-On-Board-Modulen stellt ein flächiger Verguss der Komponenten mit einem kunststoffbasierten Vergussmaterial dar. Zusammen mit weiteren funktionalen Komponenten, wie etwa Leiterbahnen und Kontaktierungselementen, werden die optoelektronischen Komponenten in Chip-On-Board-Modulen zusammen mit einem flächigen Träger durch Beschichtungen vor mechanischen Schäden und Korrosion geschützt.

Üblicherweise werden hierfür Spritzgussverfahren oder Gießverfahren mit Epoxidharzen verwendet. Diese werden als Vergussmaterial zunächst flüssig aufgebracht und dann thermisch und/oder strahlungsinduziert ausgehärtet. Da das Vergussmaterial zunächst flüssig ist, muss ein Wegfließen der Vergussmasse vermieden werden. Dies geschieht üblicherweise durch eine Form oder einen festen Rahmen.

Eine Alternative hierfür bildet das so genannte "Dam-and-Fill"-Verfahren, worin zunächst ein Kunststoffdamm auf den Träger des Chip-On-Board-Moduls aufgebracht wird, der eine Fläche des Trägers umschließt, in die anschließend eine flüssige Füllmasse aus Epoxidharz eingefüllt wird. Diese wird ausgehärtet. Damm und Füllmasse bilden zusammen die Beschichtung des Moduls. Zur Erzeugung des Damms wird bei diesem Verfahren ein zähflüssiges Polymer mit einer Dispensvorrichtung aufgebracht bzw. gezogen und danach ausgehärtet, so dass auf die von dem Damm eingeschlossene Fläche Vergussmaterial vergossen werden kann, ohne dass dieses wegfließt.

Der so erzeugte Kunststoffdamm ist allerdings nicht transparent. Daher sind derart beschichtete optoelektronische Chip-On-Board-Module, also Chip-On-Board-Module, die mit optoelektronischen Komponenten, wie beispielsweise LEDs oder Photodioden, bestückt sind, zum Rand hin in ihrer Lichtstrahlungsstärke bzw. ihrer Lichtempfindlichkeit beeinträchtigt.

Diese genannten Verfahren unter Anwendung von Epoxidharzen eignen sich weniger für optoelektronische Anwendung, da Epoxidharze nicht UV- und temperaturbeständig sind. Sie sind deshalb beispielsweise in einem Hochleistungs-UV-LED-Modul oder auch bei intensiver Sonneneinstrahlung mit UV-Anteilen, wie sie in der Photovoltaik vorkommen, nicht stabil. Sie altern bei UV-Belastung schnell und werden zerstört.

Andere Lösungen, wie beispielsweise das Aufkleben eines Glasrahmens oder einer Glaskuppe, die transparent, UV- und temperaturstabil sind, erfordern eine sehr aufwändige Montage des Rahmens und eine schwierig herzustellende Kompaktheit des Rahmens. Zudem ist eine solche Lösung mit einem höheren Gewicht verbunden als eine Vergusslösung. Für starre Glasmaterialien stellt eine meist notwendige Anpassung der thermischen Ausdehnungskoeffizienten der Verbundmaterialien zudem eine weitere Hürde dar, insbesondere wenn die späteren Produkte thermischen Zyklen ausgesetzt sind.

Bei einer Kombinationslösung aus einem Glasrahmen und einem Verguss mit einem geeigneten nicht-epoxidbasierten Material, wie z.B. einem temperatur- und UV-stabilen Silikon können kleinste Spalte zwischen Rahmen und Substrat dazu führen, dass das stark kriechfähige Silikon beim Vergießen auslaufen könnte. Außerdem muss auf dem Substrat Platz für den Rahmen vorgesehen werden. Dies beeinträchtigt eine bestmögliche Ausnutzung der Substratfläche und/oder eine gewünschte Anreihbarkeit.

Bekannte Spritzgussverfahren und Gießverfahren erfordern aufgrund der Notwendigkeit zur Verhinderung des Wegfließens des flüssigen Gießmaterials eine den Rand des Moduls abdichtende Vakuumdichtung. Dies führt zu einem Verlust nutzbarer Fläche am Modul, da der Randbereich von Bauelementen freigehalten werden muss.

Bislang ist kein Verfahren zur Realisierung einer flächigen Beschichtung für Chip-On-Board-Module bekannt, in dem sowohl im Flächen- als auch im Randbereich des Vergusses Materialien eingesetzt werden, die sowohl UV-stabil als auch temperaturstabil sind und die darüber hinaus ebenso für elektromagnetische Strahlung vom ultravioletten bis zum infraroten Spektralbereich transparent sind.

In EP 1 657 758 A2 ist ein entsprechendes Gießverfahren für LED-Einheiten auf einer Stützstruktur zur Erzeugung von Linsen für die LED-Einheiten bekannt, bei der flüssiges Silikon in eine Negativ-Form für die Linsenstruktur gefüllt wird und die Stützstruktur mit den LEDs auf die Form aufgesetzt werden, so dass die LEDs in das flüssige Linsenmaterial eingetaucht werden. Rund um die Stützstruktur des Moduls und die Form ist eine Vakuumdichtung angebracht, die am Rand der Stützstruktur bzw. des Substrats des Moduls und der Form angreift und die beiden unter hohem Druck aufeinander presst, um zu verhindern, dass das flüssige Material heraustritt. Auf diese Weise werden Linsen um die LEDs herum geformt, während die Fläche zwischen den LEDs vom Gießmaterial im Wesentlichen, bis auf hineinkriechendes Material, unbenetzt bleibt.

Mit diesem Verfahren ist es nicht möglich, optoelektronische Chip-On-Board-Module mit einer Beschichtung zu versehen, die transparent, UV- und temperaturbeständig ist und das beliebig mit optoelektronischen Komponenten bestückbar ist, insbesondere unter voller Flächenausnutzung.

Für den Einsatz von Chip-On-Board-Technologie zur Herstellung von Hochleistungs-UV-LED-Modulen, die flächig abstrahlen, oder von Photodioden- Arrays, ist ein flächiger Verguss, der die genannten Nachteile vermeidet, vorteilhafter. Aus Gründen der optischen Effizienz und einer bestmöglichen Anreihbarkeit von Modulen sollte der Verguss sowohl in der Fläche als auch im Randbereich transparent sein. Ebenso sind eine hohe Temperatur- und UV-Stabilität sowohl für die Fertigung entsprechender optoelektronischer Bauteile als auch für langzeitstabile Funktionalität relevant.

Weitere Beschichtungsverfahren für optoelektronische Chip-On-Board-Module und/oder weitere beschichtete optoelektronische Chip-On-Board-Module werden in DE 10 2008 009808 A1, JP 2009-111102 A und US 2008/112162 A1 gelehrt.

Gegenüber diesem Stand der Technik liegt der vorliegenden Erfindung somit die Aufgabe zugrunde, ein Verfahren zur Herstellung eines optoelektronischen Chip-On-Board-Moduls und ein entsprechendes optoelektronisches Chip-On-Board-Modul zur Verfügung zu stellen, bei denen eine transparente, UV- und temperaturbeständige Beschichtung vollflächig auf dem Träger möglich ist und die volle Trägerfläche zur Anordnung von optoelektronischen Komponenten zur Verfügung steht.

Diese Aufgabe wird durch ein Verfahren zur Beschichtung eines optoelektronischen Chip-On-Board-Moduls, das einen flächigen Träger umfasst, der mit einem oder mehreren optoelektronischen Komponenten bestückt ist, mit einer transparenten, UV- und temperaturbeständigen Beschichtung aus einem Silikon gelöst, das die folgenden Verfahrensschritte aufweist:
a) Vergießen eines flüssigen Silikons in eine nach oben offene Form, die Außenmaße aufweist, die den Außenmaßen des Trägers entsprechen oder diese übersteigen,
b) Einführen des Trägers in die Form, wobei die optoelektronische Komponente oder die optoelektronischen Komponenten vollständig in das Silikon eingetaucht werden und eine Oberfläche des Trägers das Silikon vollflächig berührt oder der Träger wenigstens teilweise vollflächig in das Silikon eintaucht,
c) Aushärten und Vernetzen des Silikons mit den optoelektronischen Komponenten und dem Träger, und
d) Entnehmen des Trägers mit der Beschichtung aus dem ausgehärteten Silikon aus der Form;
dadurch gekennzeichnet, dass die Verfahrensschritte a) und/oder b) und/oder c) unter einem erhöhten atmosphärischen Druck ausgeführt werden, insbesondere bei einem atmosphärischen Druck zwischen 4 und 10 bar, insbesondere zwischen 5 und 7 bar.

Im Unterschied zum Stand der Technik gemäß EP 1 657 758 A2 ist die Beschichtung, die als Ergebnis des Verfahrens auf dem optoelektronischen Chip-On-Board-Modul aufgebracht wird, bis zum Rand und ggf. über den Rand hinaus des Trägers in einer für einen Korrosionsschutz und mechanischen Schutz ausreichenden Dicke vorhanden. Diese Beschichtung ist auf der gesamten beschichteten Fläche des Trägers transparent, UV- und temperaturbeständig. Da die Beschichtung bis zum Rand des Trägers und darüber hinaus geht, ist es möglich, die optoelektronischen Komponenten beliebig auf dem Träger anzuordnen. Weil keine Vakuumdichtung notwendig ist, die umlaufend um den Träger und die entsprechende Form angebracht wird, und es daher keinen Rand gibt, der von optoelektronischen Komponenten frei bleiben muss, ist eine optimale Flächenausnutzung möglich.

Bei dem erfindungsgemäßen Verfahren werden die Kriecheigenschaften des Silikons ausgenutzt, da sie eine effiziente Benetzung und damit einen effizienten Schutz des Trägers der darauf angeordneten optoelektronischen Komponenten und anderer Aufbauten und Bauteile gewährleisten. Bei dem erfindungsgemäßen Verfahren wird flüssiges Silikon in die Form vergossen, in die anschließend der Träger kopfüber eingelegt wird. Die Füllhöhe des Silikons wird dabei derart gewählt, dass der Träger mit seiner Oberfläche gerade die Oberfläche des Silikons berührt oder darin eintaucht. Das flüssige Silikon wird anschließend mitsamt der Form und dem Substrat beispielsweise thermisch vernetzt. Alternativ oder zusätzlich dazu kann auch eine Strahlenvernetzung stattfinden. Wenn das Silikon vollständig ausgehärtet ist, wird das Substrat inklusive des nun gehärteten, anhaftenden und transparenten Vergusses der Form entnommen. Auf diese Weise ergibt sich ein UV- und temperaturstabiler Schutz von Chip-On-Board-Modulen bis hin zu Intensitäten von einigen 10 W/cm² oder sogar von einigen 100 W/cm² und ca. 200°C. Dieser Schutz ist über den gesamten Flächen- und Randbereich transparent und einheitlich und bietet auch einen mechanischen Schutz des Trägers und der Aufbauten.

Die Verfahrensschritte a) und/oder b) und/oder c) und/oder d) werden unter einem erhöhten atmosphärischen Druck ausgeführt, insbesondere bei einem atmosphärischen Druck zwischen 4 und 10 bar, insbesondere zwischen 5 und 7 bar. Der erhöhte atmosphärische Druck, der nicht ein mechanischer Druck des Trägers gegenüber der Form ist, führt dazu, dass Gasblasen in der Silikonmasse verkleinert werden, bis sie sich vollständig schließen und das Gas durch die Silikonmasse nach außen diffundiert.

Zusätzlich ist vorzugsweise vorgesehen, vor dem Verfüllen das Silikon einem Vakuum, beispielsweise bei ca. 10 mbar, auszusetzen, um Gaseinschlüsse ausgasen zu lassen. Damit wird ein gasfreies Silikonmaterial erhalten, das anschließend in die Form eingefüllt werden kann.

Wenn vorzugsweise in das flüssige Silikon optisch funktionale Materialien, insbesondere phosphoreszierende und/oder streuende Materialien oder Partikel, eingemischt sind oder werden, können die optischen Eigenschaften der optoelektronischen Chip-On-Board-Module weiter verändert werden. So kann durch phosphoreszierende Materialien eine Wellenlängenverschiebung und eine Farbveränderung des emittierten Lichts realisiert werden, während streuende Materialien oder Partikel eine Vergleichmäßigung des ausgestrahlten Lichts bewirken.

Vorzugsweise wird an einer Oberfläche der Beschichtung eine durch die Form vorgegebene oder später hinzugefügte Oberflächenstruktur erzeugt. Hierbei handelt es sich beispielsweise um Erhöhungen oder Vertiefungen, die beispielsweise an der Oberfläche des Vergusses des fertigen Moduls invers aus der Form abgeformt sind. Auf diese Weise lassen sich makroskopische und mikroskopische Primäroptiken oder allgemeine Oberflächenstrukturen, wie beispielsweise Linsen, insbesondere Mikrolinsen, oder lichtstreuende Aufrauungen, direkt auf das Modul aufbringen.

Vorteilhafterweise wird oder ist der Träger bis zu einem oder mehreren Rändern mit optoelektronischen Komponenten bestückt. Auf diese Weise wird die vorhandene Trägerfläche optimal ausgenutzt. Dies hat auch den Vorteil, dass Systeme aus mehreren Chip-On-Board-Modulen, die nebeneinander angeordnet werden, auch über die Grenzen zwischen den Trägern hinweg großflächig eine gleichmäßige Anordnung der optoelektronischen Komponenten ermöglichen. Die mindestens eine optoelektronische Komponente kann beispielsweise eine oder mehrere Fotodioden und/oder eine oder mehrere Leuchtdioden (LEDs) aufweisen. Insbesondere kann der Träger derart mit optoelektronischen Komponenten bestückt werden, dass ein Fotodioden-Array und/oder ein Leuchtdioden-Array entsteht.

Vorteilhafterweise wird der Träger randlos und/oder bis über den Rand hinweg beschichtet. Auf diese Weise ist bei einer randlosen Beschichtung die volle Designfreiheit gewahrt, während eine Beschichtung, die über den Rand hinweg geht und somit die Seitenflächen des Trägers ganz oder teilweise umschließt, zusätzlich verhindert, dass von der Seite Störungen oder Verschmutzungen in den Spalt zwischen der Beschichtung und die Oberfläche des Trägers eindringen.

Das erfindungsgemäße Verfahren und dessen Weiterbildungen bieten somit neben dem Vorteil, dass eine ganzflächige UV- und temperaturstabile transparente Beschichtung des Trägers ermöglicht wird, sowie die weiteren Vorteile, dass die Designfreiheit der Anordnung der optoelektronischen Komponenten auf dem Träger maximiert wird und aufgrund des transparenten Randes die Möglichkeiten zur nahtlosen Anreihbarkeit von Chip-On-Board-Modulen aneinander verbessert wird.

Das Verfahren kann dazu genutzt werden, optische Funktionalitäten gezielt einzustellen, mittels der Oberflächenformung und mittels der Einmischung optisch funktionaler Materialien in das Vergussmaterial. Die Härte des Silikons kann so gewählt werden, dass thermisch induzierte Spannungen gedämpft werden, die durch unterschiedliche Ausdehnungskoeffizienten zwischen Träger, Chip-On-Board-Bauteilen und Verbindungsmaterialien auftreten. Typische Shore-Härten liegen dabei zwischen der Härte eines Gels und einer Shore-Härte nahe 100.

Das Verfahren kann insbesondere in einer Weise durchgeführt werden, dass das Silikon derart geformt wird, dass mindestens eine optische Komponente, insbesondere mindestens eine Linse und/oder mindestens ein Linsen-Array, beispielsweise mindestens eine Mikrolinse und/oder mindestens einen Mikrolinsen-Array, in dem Silikon ausgebildet wird. Dies kann beispielsweise dadurch erfolgen, dass durch eine entsprechende Gestaltung der Form dem Silikon während und/oder nach dem Aushärten und Vernetzen eine entsprechende Form aufgeprägt wird, beispielsweise in Form einer Oberflächenstruktur, die der Oberfläche des Silikon die entsprechende Wirkung der mindestens einen optischen Komponente verleiht.

Weiterhin kann auch eine Dämpfung von thermisch induzierten Spannungen in dem optoelektronischen Modul oder Teilen desselben durch eine geeignete Strukturierung der Form erreicht werden. Derartige thermisch induzierte Spannungen können insbesondere bei einem Aushärtungsvorgang oder durch Temperaturänderungen durch den Betrieb des Moduls, beispielsweise des Arrays, auftreten. Zur Dämpfung dieser thermisch induzierten Spannungen kann beispielsweise eine gezielte Strukturierung der Form, die auch als Vergussform bezeichnet wird, eingesetzt werden, beispielsweise durch abschnittsweise dünne Silkonschichten zwischen optisch aktiven dickeren Silikonschichten. Letztere Möglichkeit ist beispielsweise ähnlich dem bekannten Dehnungsfugenprinzip im Straßenbau.

Das Verfahren kann weiterhin derart durchgeführt werden, dass das Chip-On-Board-Modul mindestens eine an die mindestens eine optoelektronische Komponente angrenzende Primäroptik und optional mindestens eine Sekundäroptik aufweist, wobei mindestens eine Optik ausgewählt aus der Gruppe bestehend aus der Primäroptik und der Sekundäroptik in dem Silikon ausgebildet wird.

Unter einer Optik ist dabei allgemein im Rahmen der vorliegenden Erfindung ein Element zu verstehen, welches eine sammelnde und/oder kollimierende und/oder streuende Wirkung auf ein Lichtbündel aufweist. Die Optik, insbesondere die Primäroptik und/oder die Sekundäroptik, kann beispielsweise mindestens ein optisches Element aufweisen, ausgewählt aus der Gruppe bestehend aus einer Linse, einem Reflektor, einem Diffusor, einem optischen Gitter, einem Hologramm. Auch Kombinationen der genannten und/oder anderer optischer Elemente sind denkbar.

Beispielsweise kann eine Optik mindestens eine Sammellinse und/oder mindestens eine Streulinse und/oder mindestens einen Reflektor, beispielsweise einen Spiegel, mit einer sammelnden oder streuenden Wirkung und/oder mindestens einen Diffusor aufweisen. Auch Kombinationen der genannten Wirkungen und/oder Strukturen sind denkbar. So kann beispielsweise eine Sammellinse eine raue Oberfläche aufweisen, sodass das Licht zwar kollimiert, aber auf kleineren lokalen Bereichen das Licht streut und damit beispielsweise mischt. Bei größeren Linsenstrukturen, die beispielsweise über mehreren optischen Komponenten angeordnet sein können und beispielsweise mehrere LEDs umfassen können, sind ebenso segmentweise Zusammensetzungen aus lokalen streuenden und sammelnden Bereichen denkbar.

Eine sammelnde Optik kann beispielsweise auch ganz oder teilweise als konvexe Optik ausgestaltet sein. Eine streuende Optik kann beispielsweise ganz oder teilweise als konkave Optik ausgestaltet sein. Beispielsweise kann eine Sammellinse eine konvexe Linse sein, und eine Streulinse eine konkave Linse.

Weiterhin kann, alternativ oder zusätzlich, auch eine Funktion eines Diffusors vorgesehen sein. Hierzu können beispielsweise eine oder mehrere reguläre oder irreguläre Strukturen vorgesehen sein, insbesondere auf engem Raum mit Abmessungen beispielsweise im sub-Millimeter-Bereich und typischerweise im Bereich von Mikrometern, bei denen beispielsweise schnelle Variationen zwischen konkaver und konvexer Form realisiert werden, insbesondere in Form eines rauen Profils.

Wiederum alternativ oder zusätzlich zu einem, mehreren oder allen der bereits genannten optischen Elemente kann die Optik, insbesondere die Primäroptik und/oder die Sekundäroptik, weiterhin auch andere Arten von beugenden Strukturen umfassen. Insbesondere für optoelektronische Komponenten in Form von Diodenlasern, jedoch auch für andere Arten optoelektronischer Komponenten, könnte die Optik, insbesondere die Primäroptik und/oder die Sekundäroptik, auch ein oder mehrere diffraktive optische Elemente umfassen, welche Lichtbeugende Wirkung aufweisen können, wie beispielsweise Amplituden- und/oder Phasengitterstrukturen, die beispielsweise auf der Skala der Wellenlänge des Lichts strukturiert sein können, wie beispielsweise Strichgitter in Transmission oder Reflexion, Phasengitter in Transmission oder Reflexion, Volumenhologramme oder Kombinationen der genannten und/oder anderer diffraktiver optischer Elemente. Derartige diffraktive optische Elemente als optische Elemente der Primäroptik und/oder der Sekundäroptik können beispielsweise für optoelektronische Komponenten in Form von schmalbandigen, monochromatischen Lichtquellen einsetzbar sein.

Umfasst die Optik, insbesondere die Primäroptik und/oder die Sekundäroptik, mindestens einen Reflektor, so kann der Reflektor auf verschiedene Weisen ausgestaltet sein. So können insbesondere verschiedene Profile des Reflektors, also Reflektorgeometrien und/oder Reflektorprofile, eingesetzt werden. Beispielsweise kann ein Reflektor, insbesondere in einer Schnittebene parallel zu einer optischen Achse des Reflektors, zumindest abschnittsweise mindestens ein Profil aufweisen, ausgewählt aus der Gruppe bestehend aus: einem geraden Profil, einem parabolischen Profil, einem elliptischen Profil, einem Profil einer eines Kegelschnitts, ein Freiform-Profil, ein Trapezform-Profil.

Unter einer Primäroptik ist dementsprechend eine Optik zu verstehen, welche unmittelbar an die mindestens eine optoelektronische Komponente angrenzt, so dass aus der optoelektronischen Komponente austretendes Licht unmittelbar in die Primäroptik eintritt bzw. so dass in die optische Komponente eintretendes Licht unmittelbar vor dem Eintritt in die optoelektronische Komponente die Primäroptik passiert. Beispielsweise kann die Primäroptik eine oder mehrere Linsen, insbesondere Mikrolinsen, aufweisen, welche beispielsweise in dem Silikon und/oder einer das Silikon umfassenden Beschichtung ausgebildet sind und welche unmittelbar auf der mindestens einen optoelektronischen Komponente aufsetzen oder in welche die optoelektronische Komponente ganz oder teilweise eingebettet ist. Alternativ oder zusätzlich kann die Primäroptik einen oder mehrere Reflektoren aufweisen, an welchen das aus der optoelektronischen Komponente austretende Licht reflektiert und dabei gebündelt oder gestreut wird, bzw. an welchen das in die optoelektronische Komponente eintretende Licht gebündelt oder gestreut, oder anderweitig abgelenkt, wird.

Der Begriff der Primäroptik charakterisiert also mindestens ein strahlformendes Element, welches auf einem Lichtweg der optoelektronischen Komponente benachbart ist, ohne dass weitere optische Komponenten zwischen der Primäroptik und der optoelektronischen Komponente angeordnet sind, wobei der Begriff der Primäroptik unabhängig davon verwendet wird, ob weitere Optiken, insbesondere eine Sekundäroptik, vorhanden sind oder nicht.

Unter einer Sekundäroptik ist dementsprechend eine Optik zu verstehen, welche derart in dem optoelektronischen Chip-On-Board-Modul angeordnet ist, dass auf einem Lichtweg zwischen der Sekundäroptik und der mindestens einen optoelektronischen Komponente das Licht mindestens eine weitere Optik passieren muss. So kann beispielsweise aus der optoelektronischen Komponente austretendes Licht zunächst eine Primäroptik passieren, bevor das Licht eine Sekundäroptik passiert. Alternativ kann in die optoelektronische Komponente eintretendes Licht zunächst die Sekundäroptik passieren, anschließend die Primäroptik, bevor das Licht schließlich in die optoelektronische Komponente eintritt.

Die mindestens eine optionale Primäroptik kann beispielsweise mindestens eine Linse, insbesondere eine Mehrzahl von Linsen, insbesondere Mikrolinsen, aufweisen. Beispielsweise kann das optoelektronische Chip-On-Board-Modul eine Mehrzahl optoelektronischer Komponenten aufweisen, welche in einer Matrix und/oder einem Array angeordnet sind, beispielsweise einem Leuchtdioden-Array und/oder einem Fotodioden-Array. Dieser Mehrzahl optoelektronischer Komponenten kann eine Mehrzahl von Elementen einer Primäroptik zugeordnet sein, beispielsweise derart, dass jeweils einer optoelektronischen Komponente oder einer Gruppe optoelektronischer Komponenten genau eine Komponente der Primäroptik und/oder eine definierte Gruppe von Komponenten der Primäroptik zugeordnet ist. So kann beispielsweise auf jeder optoelektronischen Komponente genau eine Linse aufsitzen, oder es kann auf einer Gruppe optoelektronischer Komponenten eine gemeinsame Linse für diese Gruppe aufsitzen.

Die mindestens eine optionale Sekundäroptik kann beispielsweise mindestens einen Reflektor und/oder mindestens eine Linse aufweisen. Beispielsweise kann wiederum eine Zuordnung von Elementen der Sekundäroptik zu optoelektronischen Komponenten erfolgen, beispielsweise wiederum in dem jedem Element oder Gruppen von Elementen eines Arrays der optoelektronischen Komponenten jeweils ein oder mehrere Elemente der Sekundäroptik zugeordnet sind. Beispielsweise kann die Sekundäroptik eine Mehrzahl von Reflektoren, beispielsweise eine Mehrzahl von Hohlspiegeln, umfassen, welche beispielsweise in einer Matrix und/oder einem Array angeordnet sein können. Jedem Hohlspiegel kann beispielsweise eine optoelektronische Komponente und/oder eine Gruppe optoelektronischer Komponenten zugeordnet sein, beispielsweise indem die optoelektronische Komponente ganz oder teilweise innerhalb des Hohlspiegels angeordnet ist.

Das Verfahren kann allgemein auch derart durchgeführt werden, dass die Primäroptik und die Sekundäroptik ganz oder teilweise aus unterschiedlichen Materialien hergestellt werden, beispielsweise unterschiedlichen Silikonen der beschriebenen Art. Insbesondere können die Primäroptik und die Sekundäroptik ganz oder teilweise aus Materialien hergestellt werden, beispielsweise mittels aufeinander folgender Vergussverfahren der beschriebenen Art, welche unterschiedliche Brechungsindices aufweisen. Beispielsweise kann die Primäroptik ganz oder teilweise unter Verwendung eines Silikons mit einem ersten Brechungsindex n1 hergestellt werden, und die Sekundäroptik ganz oder teilweise unter Verwendung eines Silikons mit einem zweiten Brechungsindex n2.

Beispielsweise kann auf diese Weise ein optoelektronisches Chip-on-Board-Modul hergestellt werden, welches eine Primäroptik, beispielsweise ein primäroptisches Linsen-Array, mit Material n1 aufweist, sowie eine Sekundäroptik, welche beispielsweise eine Kombination aus mindestens einem Reflektor und mindestens einer Silikonlinse aufweisen kann, wobei beispielsweise die Silikonlinse ausgebildet sein kann zwischen den begrenzenden Seiten des Reflektors. Die Silikonlinse der Sekundäroptik kann beispielsweise aus einem zweiten Vergussmaterial hergestellt sein mit einem Brechungsindex n2, wobei n1 ungleich n2 sein kann. Allgemein können die Primäroptik und/oder die Sekundäroptik erfindungsgemäß hergestellt werden.

Die der Erfindung zugrunde liegende Aufgabe wird auch durch ein nach dem erfindungsgemäßen Verfahren hergestelltes optoelektronisches Chip-On-Board-Modul, umfassend einen flächigen Träger, der mit einer oder mehreren optoelektronischen Komponenten bestückt ist, mit einer transparenten, UV- und temperaturbeständigen Beschichtung aus einem Silikon gelöst, das sich dadurch auszeichnet, dass eine Oberfläche des Trägers, die mit einer oder mehreren optoelektronischen Komponenten bestückt ist, randlos mit dem Silikon beschichtet ist.

Dieses erfindungsgemäße optoelektronische Chip-On-Board-Modul weist die gleichen Vorteile auf wie das oben beschriebene erfindungsgemäße Verfahren, da es randlos mit einem Silikon beschichtet ist, das transparent, UV- und temperaturbeständig ist. Die komplette Fläche des Trägers steht zur Anordnung von optoelektronischen Komponenten zur Verfügung, so dass die Designfreiheit maximiert ist.

Vorzugsweise ist der Träger auch an seinen Seitenflächen wenigstens teilweise mit dem Silikon beschichtet, so dass der Schutz des Chip-On-Board-Moduls weiter erhöht wird.

In einer vorteilhaften Weiterbildung weist das Silikon eine Beimischung von optisch funktionalen Materialien, insbesondere phosphoreszierenden und/oder streuenden Materialien oder Partikeln, auf. Damit lassen sich die Wellenlängen und Farbeigenschaften des Materials einstellen, insbesondere, wenn es sich bei den optoelektronischen Chip-On-Board-Modulen um lichterzeugende Module, beispielsweise LED-Module und/oder UV-LED-Module handelt.

Ebenfalls vorteilhafterweise weist die Beschichtung eine Oberflächenstruktur auf, insbesondere Linsen, vorzugsweise Mikrolinsen, oder lichtstreuende Aufrauhungen. Diese Oberflächenstruktur kann durch Abformung aus der Form erzeugt werden oder durch nachträgliche Bearbeitung.

In einer weiteren, alternativ oder zusätzlich realisierbaren Ausgestaltung weist die Beschichtung mindestens eine optische Komponente auf. Bezüglich möglicher Ausgestaltungen der optischen Komponente kann auf die obige Beschreibung verwiesen werden. Insbesondere können eine oder mehrere optische Elemente enthalten sein, beispielsweise als primäroptische und/oder sekundäroptische Elemente, welche mindestens eine Wirkung aufweisen, ausgewählt aus der Gruppe bestehend aus einer sammelnden Wirkung, einer streuenden Wirkung, einer diffusiven Wirkung und einer beugenden Wirkung. Beispielsweise können ein oder mehrere optische Elemente als primäroptische und/oder sekundäroptische Elemente enthalten sein, ausgewählt aus der Gruppe bestehend aus einer Sammellinse, insbesondere einer konvexen Linse, einer Streulinse, insbesondere einer konkaven Linse, einem Reflektor, einem Diffusor, einem optischen Gitter, einem Hologramm. Auch Kombinationen der genannten und/oder anderer optischer Elemente können enthalten sein. Insbesondere können eines oder mehrere der genannten optischen Elemente als Array angeordnet sein. Beispielsweise kann die Beschichtung mindestens ein Array aufweisen, welches mehrere der genannten optischen Elemente gleicher oder verschiedener Art enthält. Das Array kann im Rahmen der vorliegenden Erfindung in Form einer Oberflächenstruktur durch Abformung aus der Form erzeugt werden. Insbesondere kann die Beschichtung mindestens eine Linse und/oder mindestens einen Linsen-Array aufweisen.

Beispielsweise kann die Beschichtung mindestens ein Linsen-Array umfassen. Dieses Linsen-Array kann mehrere Linsen umfassen, deren Dimensionen an die jeweilige Anwendung angepasst sein können. So können Linsen umfasst sein, welche in ihrem Durchmesser oder Äquivalentdurchmesser bei einer Draufsicht auf den Träger Abmessungen aufweisen, die von wenigen Mikrometern oder hundert Mikrometern bis hin zu Dezimetern betragen können. Insbesondere kann das Linsen-Array ganz oder teilweise als Mikrolinsen-Array ausgestaltet sein und kann eine oder mehrere Mikrolinsen umfassen, beispielsweise mit Dimensionen im sub-Millimeter-Bereich. Allgemein kann die Optik beispielsweise mindestens ein mikrooptisches Element umfassen und/oder mindestens eine Mikrooptik. Wie oben ausgeführt, kann die Dimensionierung der Optik und/oder der optischen Elemente allgemein auf die Anwendung angepasst sein. Beispielsweise können ein oder mehrere optische Elemente enthalten sein, beispielsweise eine oder mehrere Linsen, insbesondere innerhalb eines Linsen-Arrays, welche einen für optoelektronische Komponenten wie beispielsweise LEDs typischen Durchmesser von 1-10 mm aufweisen, insbesondere einen Durchmesser von 2-4 mm. So weisen beispielsweise typische Hochleistungs-LEDs eine Emissionsfläche von 1mm² auf, welche mit den genannten Dimensionen der optischen Elemente vollständig oder teilweise abgedeckt werden kann.

Die Optik, insbesondere eines oder mehrere optische Elemente der Primäroptik und/oder der Sekundäroptik, kann Krümmungsänderungen aufweisen, insbesondere auf lokalen Bereichen oder Teilbereichen, beispielsweise auf einer Skala im sub-Millimeter-Bereich. Auf dieser sub-Millimeter-Skala kann die Optik damit lokal benachbarte Strahlengänge parallel einfallenden Lichts beeinflussen. So können beispielsweise Krümmungsstrukturen mit äquivalenten lokalen Radien im sub-Millimeter-Bereich als ein oder mehrere optisch wirksame Elemente der Primäroptik und/oder der Sekundäroptik eingesetzt werden.

Wie oben im Rahmen der Beschreibung des Verfahrens ausgeführt, kann das Chip-On-Board-Modul mindestens eine an die mindestens eine optoelektronische Komponente angrenzende Primäroptik und optional mindestens eine Sekundäroptik aufweisen. Mindestens eine Optik ausgewählt aus der Gruppe bestehend aus der Primäroptik und der Sekundäroptik kann zumindest teilweise in der Beschichtung ausgebildet sein, insbesondere in einer Oberflächenstruktur der Beschichtung.

Wie oben ausgeführt, kann die mindestens eine Beschichtung, beispielsweise die erste Beschichtung und/oder die zweite Beschichtung, insbesondere mindestens ein Silikon umfassen. Die Beschichtung und das optoelektronische Chip-On-Board-Modul können insbesondere mittels eines erfindungsgemäßen Verfahrens hergestellt bzw. beschichtet sein. Allgemein können die Primäroptik und die optionale Sekundäroptik in derselben mindestens einen Beschichtung ausgebildet sein. Alternativ kann die Primäroptik auch in mindestens einer ersten Beschichtung ausgebildet sein und die Sekundäroptik ganz oder teilweise in mindestens einer zweiten Beschichtung, welche von der ersten Beschichtung verschieden sein kann. Insbesondere können die Primäroptik und die optionale Sekundäroptik auch unter Verwendung unterschiedlicher Beschichtungen mit unterschiedlichen Brechungsindices ausgebildet sein. Beispielsweise kann, wie oben beschrieben, die Primäroptik ganz oder teilweise in mindestens einer ersten Beschichtung, beispielsweise einer ersten Silikonbeschichtung, mit einem ersten Brechungsindex n1 ausgebildet sein, und die Sekundäroptik kann ganz oder teilweise in mindestens einer zweiten Beschichtung ausgebildet sein, welche einen zweiten Brechungsindex n2 ≠ n1 aufweisen kann. Die Beschichtungen können beispielsweise in unterschiedlichen Beschichtungsschritten nacheinander aufgebracht werden, wobei beispielsweise eine oder beide der Beschichtungen unter Verwendung eines erfindungsgemäßen Beschichtungsverfahrens auf das optoelektronische Chip-On-Board-Modul aufgebracht werden können.

Für weitere mögliche Ausgestaltungen der Primäroptik und/oder der Sekundäroptik, welche einzeln oder beide ganz oder teilweise in der Beschichtung ausgebildet sein können, kann auf die obige Beschreibung des Verfahrens verwiesen werden.

Vorzugsweise ist der Träger bis an einen Rand oder bis kurz vor einen Rand mit optoelektronischen Bauteilen bestückt. Dies umfasst auch die Möglichkeit, dass der Träger bis an mehrere oder alle Ränder oder bis kurz vor diesen Rändern mit optoelektronischen Bauteilen bestückt ist. Dies erlaubt die effektive Ausnutzung der gesamten zur Verfügung stehenden Oberfläche des Trägers, da der Rand nicht freigelassen werden muss, da eine Vakuumdichtung wie aus dem Stand der Technik bekannt, entfällt. Damit kann ein gleichbleibender Pitch von optoelektronischen Kompomenten auch über die Grenzen zwischen benachbarten Modulen hinweg eingehalten werden.

Das erfindungsgemäße optoelektronische Chip-On-Board-Modul ist nach einem erfindungsgemäßen Verfahren wie oben beschrieben hergestellt.

Ferner wird die der Erfindung zugrunde liegende Aufgabe auch durch ein System mit zwei oder mehr oben beschriebenen optoelektronischen Chip-On-Board-Modulen gelöst, wobei die Träger der optoelektronischen Chip-On-Board-Module bündig oder mit einem definierten Abstand zueinander nebeneinander angeordnet sind, wobei sich insbesondere aufgrund einer randständigen Bestückung der Träger mit optoelektronischen Komponenten eine auch über die Grenzen zwischen benachbarten Trägern hinweg regelmäßige Anordnung und Beabstandung von optoelektronischen Komponenten ergibt. Unter einem definierten Abstand ist dabei allgemein ein gewählter fester und in der Regel ortsabhängig konstanter Abstand zwischen zwei benachbarten Modulen zu verstehen. Dieser ist beispielsweise zur Berücksichtigung von Materialtoleranzen zu wählen, um eine Fertigbarkeit zu gewährleisten oder um bestimmte Längen des Systems, beispielsweise einer Lampe, zu erreichen.

Die zu den Erfindungsgegenständen, also das erfindungsgemäße Verfahren, das erfindungsgemäße optoelektronische Chip-On-Board-Modul und das erfindungsgemäße System, genannten Eigenschaften, Merkmale und Vorteile gelten uneingeschränkt auch für die jeweils anderen Erfindungsgegenstände.

Das vorgeschlagene Verfahren, das optoelektronische Chip-On-Board-Modul und das System lassen sich auf zahlreiche Weisen vorteilhaft einsetzen. Beispielsweise lassen sich auf diese Weise Bestrahlungsvorrichtungen mit hoher Bestrahlungsstärke in Chip-On-Board-Technologie realisieren. Aus dem Stand der Technik sind aufgrund der typischerweise notwendigen geringen Abstände zwischen den LEDs (sog. Pitch) nur wenige Verfahren bekannt, mit denen überhaupt strahlformende Mikrolinsen über den einzelnen LEDs eines LED-Arrays durch ein Vergussmaterial realisiert werden können. Ebenso ist die gezielte Beeinflussung durch eine positionsabhängige Anpassung der Abstrahlcharakteristik der einzelnen Mikrolinsen (-optiken) in einer Array-Anordnung vor dem LED-Strahler und auch im Randbereich mit bisherigen Verfahren praktisch nicht möglich. Mittels des vorgeschlagenen Verfahrens sind derartige Aufbauten jedoch problemlos möglich. Insbesondere lassen sich Mikrolinsen-Primäroptiken und/oder Mikrolinsen-Sekundäroptiken für LED Arrays realisieren, wobei die Sekundäroptiken optimal auf die Primäroptiken abgestimmt sein können und/oder umgekehrt. Durch die Verknüpfung dieses Primäroptik-Ansatzes und einer oder mehrerer Sekundäroptiken werden neue Konzepte zur Steigerung der Bestrahlungsstärke in signifikanten Arbeitsabständen von >10 mm in Bezug auf das Licht-Austrittsfenster der LED-Strahler eröffnet.

Mittels des vorgeschlagenen Verfahrens ist insbesondere eine individuelle Ausformung einzelner Linsen, insbesondere Mikrolinsen, über einer, mehreren oder allen optoelektronischen Komponenten, insbesondere den LEDs einer LED-Array-Konfiguration, möglich. Auf diese Weise lässt sich beispielsweise eine Abstrahlcharakteristik eines gesamten LED-Arrays gezielt beeinflussen, beispielsweise zum Zweck einer Homogenisierung und/oder einer Strahlbündelung.

Wie oben ausgeführt, lässt sich das vorgeschlagene Verfahren insbesondere zur Herstellung von optoelektronischen Chip-On-Board-Modulen und Systemen einsetzen, welche mindestens eine Primäroptik und gegebenfalls mindestens eine Sekundäroptik aufweisen. Dabei können die Primäroptik und/oder die Sekundäroptik ganz oder teilweise erfindungsgemäß hergestellt werden, in dem die Primäroptik und/oder die Sekundäroptik in dem Silikon bzw. der Beschichtung ausgebildet wird.

Systeme mit Primäroptiken und Sekundäroptiken sind aus dem Stand der Technik vom Konzept her grundsätzlich aus anderen Bereichen bekannt und können nunmehr erfindungsgemäß realisiert und hergestellt werden. So ist der Einsatz von Sekundäroptiken beispielsweise für bereits gepackte LEDs (z.B. LEDs in einem SMD-Gehäuse) grundsätzlich bekannt. Weiterhin werden LEDs in Reflektorgehäusen eingesetzt (assembliert) und Gehäuse mit einem Vergussmaterial verschlossen, das optische Eigenschaften zur Strahlformung aufweist, wie z.B. die Formung des Vergussmaterials zu Linsen. Derartige Gehäuse, sind teilweise bereits am Markt verfügbar. In den meisten gehausten LED-Produkten umfasst die optische Funktionalität des Gehäuses jedoch nur eine strahlformende Optikvariante, entweder einen Reflektor, realisiert durch eine Vertiefung in die die LED hineingesetzt wird, oder eine Linse, wobei die LED dann i.d.R. auf ein flaches Substrat aufgesetzt wird. Für diese Bauteile wird dann im Bedarfsfall eine weitere Sekundäroptik (Linse oder Reflektor, oder eine Kombination aus beidem) über die gehausten LEDs aufgesetzt. Für LED-Arrays ist der Einsatz von Mikroreflektoren in US 7,638,808 beschrieben. Dabei wird ein Substrat verwendet, welches Kavitäten aufweist, in welche LEDs eingesetzt werden. Seitenwände dieser einzelnen Kavitäten dienen als Reflektor, welcher angepasst gestaltet werden kann. Ebenso wird die Verwendung eines zusätzlichen strahlformenden Vergusses, mit dem die Kavitäten verschlossen werden, beschrieben. Somit handelt es sich um eine Kombination aus Mikro-Primärlinse und Mikro-Primärreflektor, für einzelne LEDs in einer Array-Anordnung. Auch derartige bekannte Konzepte, welche mit herkömmlichen Verfahren nur vergleichsweise aufwändig realisierbar sind, lassen sich mit dem erfindungsgemäß vorgeschlagenen Verfahren einfach und zuverlässig realisieren.

Weiterhin lassen sich erfindungsgemäß Konzepte mit Primäroptik und Sekundäroptik realisieren, bei welchen eine oder mehrere Sekundäroptiken verwendet werden, die das Licht beispielsweise von mehreren Leuchtdioden mit jeweils zugeordneten Mikro-Primäroptiken weiter bündeln. Diese Optiken sind beispielsweise auf LED-Arrays, Segmente von LED-Arrays, Fotodioden-Arrays oder Segmente von Fotodioden-Arrays aufsetzbar, so dass beispielsweise eine Sekundäroptik mehrere LEDs eines LED Arrays mit Mikrooptiken beinhaltet.

Die Erfindung lässt sich insbesondere im Bereich der Bestrahlungstechnik und der Belichtungstechnik einsetzen, beispielsweise in industriellen Prozessen. In industriellen Prozessen gibt es eine Vielzahl von LED-Belichtungs- und Bestrahlungsanwendungen, insbesondere im ultravioletten und infraroten Spektralbereich. Zahlreiche Beispiele sind hier zu nennen, wie beispielsweise eine Trocknung von Tinten, eine Anwendung der Bestrahlung im Bereich der UV-Härtung beispielsweise von Klebstoffen, Tinten, Farben, Lacken und Vergussmaterialien, sowie ein Einsatz in Belichtungsanwendungen.

Insbesondere lassen sich mittels der vorliegenden Erfindung die typischerweise für Bestrahlungsanwendungen geltenden Anforderungen gut realisieren. Die Grundanforderungen sind dabei in der Regel, dass in dem verwendeten Wellenlängenbereich eine hohe bzw. eine an die jeweilige Anwendung angepasste Bestrahlungsstärke realisierbar ist, wobei typischerweise Bestrahlungsstärken von einigen 10 µW/cm² bis hin zu mehreren zehn oder wenigen hundert W/cm² in einem einstellbaren Abstand von typischerweise wenigen Millimetern bis hin zu einem Meter oder mehr realisierbar sind. Gleichzeitig sollen typischerweise bestimmte, für den jeweiligen Prozess notwendige, Lichtverteilungen erreichbar sein. Die Lichtverteilung kann dabei beispielsweise eine homogene Feldverteilung in einem bestimmten Prozessfenster oder eine schmale Linie sein. So umfassen beispielsweise aktuelle Anwendungen in der Druckindustrie die Bereiche Ink-Jet, Bogen-Offset, Siebdruck, Tiefdruck und Flexodruckverfahren. Für Bogendruckverfahren werden in der Regel hohe Bestrahlungsstärken von 2-20 W/cm² in Abständen von 20-200 mm für ultraviolettes LED-Licht im Bereich von 360-420 nm benötigt.

Die Mindestanforderung an die für den jeweiligen Prozess notwendige Bestrahlungsstärke ist in der Regel auch materialabhängig. Für UV-Härtungsanwendungen (UV-Curing) werden beispielsweise in der Regel Photoinitiatoren eingesetzt, die zumeist erst bei Überschreiten eines Schwellwertes der Bestrahlungsstärke eine hinreichend schnelle Reaktion zur Verkettung der Monomere (Polymerisation) ermöglichen, so dass ein gutes Härtungsergebnis erreicht wird. Hierbei spielt beispielsweise bei einer Oberflächenhärtung auch eine Inhibierung durch Sauerstoff der Polymerisation entgegen.

Die Grundlage für eine effiziente Realisierung von Hochleistungs-LED Strahlern, die eine Vielzahl von LED-Chips aufweisen können und welche optische Leistungen von einigen W bis hin zu mehreren 10 kW besitzen können und die zudem in der Regel speziellen Anforderungen an die jeweiligen Beleuchtungsprofile genügen müssen, ist eine möglichst hohe, effiziente Lichtausbeute aus einer minimal notwendigen Abstrahlungsfläche. Effiziente und kompakte Strahler weisen Emissionsflächen von wenigen cm² bis hin zu einigen hundert cm² auf. Um die dafür notwendigen hohen Packungsdichten von beispielsweise bis zu 20 Stk. 1mm² große LED Chips/cm² zu erreichen und die, aufgrund der typischen Effizienzen von UV-LEDs im Bereich von 1-50% einhergehenden, hohen thermischen Lasten möglichst gering halten zu können, lassen sich erfindungsgemäße optoelektronische Chip-On-Board-Module und erfindungsgemäße Systeme mit mehreren optoelektronischen Chip-On-Board-Modulen gut einsetzen. Beispielsweise werden derzeit Chip-On-Board-Module entwickelt mit optoelektronischen Komponenten in Form von Chips mit einer Fläche von 1,3x1,3 mm². Zukünftige Entwicklungen lassen Module mit Chips bis hin zu mehreren mm² Chipfläche erwarten.

Von Leuchtdioden emittiertes Licht ist in der Regel aufgrund der LED-typischen Abstrahlcharakteristik divergent. Moderne LEDs sind typischerweise Oberflächenemitter, die in den Halbraum abstrahlen und in der Regel die Abstrahlungscharakteristik eines Lambertschen Strahlers besitzen. Durch diese divergente Abstrahlungscharakteristik ergibt sich eine starke Abhängigkeit der Bestrahlungsstärke vom Arbeitsabstand, also beispielsweise im Abstand zwischen dem zu bestrahlenden Objekt und dem optoelektronischen Chip-On-Board-Modul, insbesondere dem LED-Strahler. Erfindungsgemäß lässt sich jedoch das emittierte Licht von LEDs in einer LED-Array-Konfiguration effizient nutzen und eine hohe Bestrahlungsstärke auch in großen Arbeitsabständen realisieren. Insbesondere lassen sich angepasste Optiken realisieren, die zum einen die Auskopplung des Lichts aus den optoelektronischen Chip-On-Board-Modulen, insbesondere den LED-Chips, maximieren können und zum anderen eine hohe Bestrahlungsstärke und eine definierte Feldverteilung in einem bestimmten Arbeitsabstand generieren können.

Für sehr große Arbeitsabstände, beispielsweise Arbeitsabstände von mindestens 20 mm, kann insbesondere das emittierte Licht stark kollimiert werden. Der Einsatz einer Primäroptik ohne weitere Optiken stößt jedoch in der Regel an Grenzen, da die LED im Falle der Mikrolinsenoptik nicht als Punktlichtquelle betrachtet werden kann. Dies ist insbesondere dadurch bedingt, dass die Größe der Linse, welche einen Durchmesser von typischerweise 1-10 mm aufweist, und die Größe der LED, welche typischerweise eine Kantenlänge von 1 mm aufweist, vergleichbar sind. Daher lässt sich das Licht in der Regel nicht vollständig kollimieren, und mit zunehmender Kollimation nimmt darüber hinaus durch Reflexionsverluste in der Linse die Effizienz der Linse ab. Für eine optimierte Lösung kann daher, beispielsweise neben mindestens einer optimierten Primäroptik, bei sehr hohen Anforderungen an die Bestrahlungsstärke und an den Arbeitsabstand erfindungsgemäß mindestens eine zusätzliche Sekundäroptik realisiert werden, um eine hohe Kollimation oder gar Fokussierung des Lichts zu erreichen und um die Systemeffizienz zu maximieren.

Insbesondere lässt sich mindestens eine Sekundäroptik realisieren, die in Form einer Reflektoroptik mit mindestens einem Reflektor oder in Form einer Kombination aus mindestens einer Reflektoroptik und mindestens einer Linsenoptik. In dieser Kombination kann das Licht, das nicht direkt durch die Primäroptik in das Bestrahlungsfeld gerichtet werden kann, beispielsweise vom Reflektor "gesammelt" und in ein Bestrahlungsfeld umgelenkt werden. Weiterhin kann in einer erfindungsgemäßen Umsetzung eine Primäroptik auf eine Sekundäroptik optimiert werden und umgekehrt, so dass eine beidseitige Anpassung von Primär- und Sekundäroptik möglich ist.

Erfindungsgemäß kann insbesondere zur Beeinflussung einer Richtcharakteristik, insbesondere einer Abstrahlcharakteristik des von den LEDs emittierten Lichts, mindestens eine Optik verwendet werden. Dementsprechend können, wie oben ausgeführt, das erfindungsgemäße optoelektronische Chip-On-Board-Modul und/oder das erfindungsgemäße System mindestens eine Optik aufweisen. Bei der Verwendung von mehreren Optiken kann dabei, wie oben ausgeführt, zwischen Primär- und Sekundäroptik unterschieden werden. Beispielsweise kann die Primäroptik ein Linsenarray aus einem transparenten Vergussmaterial umfassen, welches, beispielsweise mittels eines erfindungsgemäßen Verfahrens, direkt auf den mit den optoelektronischen Komponenten, beispielsweise den LEDs, bestückte Träger aufgebracht werden kann, so dass die Primäroptik beispielsweise fest mit den LED-Chips verbunden sein kann. Beispielsweise für UV-LEDs kann ein UV-stabiles, thermisch härtendes Silikon verwendet werden, wobei alternativ oder zusätzlich auch eine Verwendung anderer Materialien denkbar ist, beispielsweise die Verwendung lichthärtender Acrylate, PMMA, Polycarbontat oder anderer Materialien oder von Kombinationen der genannten und/oder anderer Materialien. Wie oben ausgeführt, wird der Begriff der Primäroptik unabhängig davon verwendet, ob diese Primäroptik einer weiteren Optik kombiniert wird oder nicht.

Erfindungsgemäß lassen sich zahlreiche optisch funktionale Geometrien realisieren, beispielsweise Linsenformen und/oder Streuformen. Diese Geometrien lassen sich anpassen an die zur Erzeugung der für die Anwendungen jeweils notwendigen Bestrahlungsstärkeprofile. Lediglich Formen mit signifikantem Hinterschnitt sind in der Regel schwierig realisierbar, da es sich bei dem erfindungsgemäßen Verfahren um ein Abgussverfahren handelt. Gut realisierbar sind jedoch zum Beispiel Formen ausgewählt aus: sphärischen Linsenoptiken, insbesondere in Form von zylindrischen und/oder rotationssymmetrischen Optiken, sowohl symmetrischer als auch asymmetrischer Form; asphärischen Optiken, insbesondere in Form von zylindrischen und/oder rotationssymmetrischen Optiken, sowohl symmetrischer als auch asymmetrischer Form; Freiformoptiken, insbesondere in Form von zylindrischen und/oder rotationssymmetrischen Optiken, sowohl symmetrischer als auch asymmetrischer Form; Fresneloptiken, insbesondere in Form von zylindrischen und/oder rotationssymmetrischen Optiken, sowohl symmetrischer als auch asymmetrischer Form; polygonalen und/oder facettierten Optiken, insbesondere in Form von zylindrischen und/oder rotationssymmetrischen Optiken, sowohl symmetrischer als auch asymmetrischer Form; rauen Strukturen, beispielsweise zur Lichtstreuung oder zur statistisch verteilten Lichtbeugung; Strukturen mit strukturierter Oberfläche. Auch Kombinationen der genannten Formen und/oder anderer Formen sind möglich.

Die Möglichkeit der Realisierung einer Primäroptik bietet mehrere Funktionen und Vorteile. So kann insbesondere mindestens eine Linse direkt über einer optoelektronischen Komponente, beispielsweise direkt über einer LED, positioniert werden. Dadurch hat die Linse, im Gegensatz zu einer Linse im üblichen Sinne, nur eine Austrittsseite und keine Eintrittsseite, da das aus der LED austretende Licht unmittelbar in das Material der Linse eintreten kann. Dies führt zu einer Steigerung der Auskoppeleffizienz des Lichts aus der LED bzw. aus dem System, da das Licht eine Grenzfläche weniger passieren muss und die Brechungsindexanpassung zwischen LED und Verguss zu einer Verminderung der internen Totalreflexion innerhalb der LED führt, aber auch im Vergleich zur Totalreflexion bei einem Planverguss.

Durch die Geometrie der Linse können weiterhin Reflexionsverluste an der Grenzfläche zwischen Verguss und Luft gezielt minimiert werden. Dies bewirkt zum Beispiel im Vergleich zu einem Planverguss eine weitere Effizienzsteigerung. Für Silikon ist in der Regel eine Steigerung der Auskopplungseffizienz im Vergleich zu einem Planverguss von ca. einem Faktor 2 möglich.

Für jede einzelne optoelektronische Komponente, beispielsweise für jede einzelne LED, kann eine den Zielvorgaben angepasste Strahlformung generiert werden, so dass sowohl eine Optimierung der Geometrie der Optik, beispielsweise der Linsengeometrie, unter Berücksichtigung der direkten Lenkung des Lichts in die Ziel-Bestrahlungsfläche, als auch in Hinblick auf Auskopplungseffizienz und auch auf die Anpassung an die Eigenschaften einer Sekundäroptik durchgeführt werden kann.

Weiterhin können Linsenflächen räumlich gesehen sehr nah, beispielsweise in einem Abstand von weniger als 1 mm, an den optoelektronischen Komponenten, beispielsweise den LEDs, angeordnet werden. Dadurch kann beispielsweise das Licht eines großen Raumwinkelbereiches, insbesondere bis hin zu einem Raumwinkelbereich von mehr als 70°, ausgenutzt werden, was eine Effizienzsteigerung bewirken und hohe Leistungsdichten ermöglichen kann.

Der Verguss bzw. die Beschichtung, insbesondere der Silikonverguss, schützt die optoelektronischen Komponenten, insbesondere die LEDs, weiterhin vor äußeren Einflüssen wie Schmutz, Feuchtigkeit und mechanischen Einflüssen.

Weiterhin weist das Vergussmaterial in der Regel einen höheren Brechungsindex als Luft auf. So liegt der Brechungsindex des Vergussmaterials typischerweise bei n >1, beispielsweise bei n = 1,3-1,6. Damit liegt in der Regel eine Brechungsindexanpassung zwischen dem Halbleitermaterial der optoelektronischen Komponenten, insbesondere des LED Chips, deren Brechungsindex typischerweise bei n = 3-4 liegt, und dem Vergussmaterial vor. Dadurch wird die Lichtauskopplung aus dem optoelektronischen Chip-On-Board-Modul verbessert und die Gesamteffizienz positiv beeinflusst.

Alternativ oder zusätzlich zur Verwendung einer oder mehrerer Linsen in der Primäroptik kann die Primäroptik weiterhin einen oder mehrere Reflektoren aufweisen. So kann die Primäroptik beispielsweise ein Mikroreflektor-Array aufweisen, in dem beispielsweise jede optoelektronische Komponente, beispielsweise jede LED, in einer kleinen Kavität angeordnet sein kann, deren reflektierende Wände den Mikroreflektor bilden. Eine Array-Primäroptik, umfassend eine Kombination mindestens einer Mikrolinse und mindestens eines Mikroreflektors, ist ebenso möglich.

In analoger Weise lässt sich auch die mindestens eine optionale Sekundäroptik beispielsweise in Form eines oder mehrerer refraktiver Elemente, beispielsweise eines oder mehrerer Linsenelemente, und/oder in Form eines oder mehrerer reflektiver Elemente realisieren.

Je nach Anwendungsprozess können die Anforderungen an das abgestrahlte Licht auch variieren. Wird beispielsweise eine Anordnung aus Substraten bzw. Trägern in einem Durchlauf-Prozess verwendet, so ist es quer zu Laufrichtung in der Regel wichtig, eine homogene und intensive Bestrahlungsstärke zu realisieren, während in Laufrichtung in der Regel im Wesentlichen auf eine Maximierung der einzubringenden Dosisleistung von Bedeutung ist. Konkret bedeutet dies beispielsweise im Falle eines Linienstrahlers, dass es von Vorteil sein kann, die LEDs in eine Raumrichtung sehr nah, beispielsweise in einem Abstand von 0,05 - 5 mm, beieinander zu positionieren, während es in der dazu orthogonalen Raumrichtung sinnvoller sein kann, den Abstand zwischen den LEDs zu vergrößern, beispielsweise auf mehr als 1 mm, um auf diese Weise beispielsweise Raum für eine effiziente kollimierende Primär- und/oder Sekundäroptik zu erhalten. Hingegen wird eine gleichmäßige Verteilung der optoelektronischen Komponenten, beispielsweise eine gleichmäßige LED-Verteilung, in der Regel zur Realisierung eines Flächenstrahlers, der eine Fläche homogen beleuchten soll, günstig sein.

Generell können erfindungsgemäß gleiche oder unterschiedliche oder auch positionsabhängig verschiedene Geometrien realisiert werden. Beispielsweise können Abstände zwischen den optoelektronischen Komponenten, beispielsweise den LEDs, und/oder den Mikrolinsen in einer oder beiden Raumrichtungen innerhalb eines Arrays realisiert werden. Somit kann eine Verteilung der optoelektronischen Komponenten und/oder eine Verteilung der Elemente der Primäroptik und/oder der Sekundäroptik, beispielsweise eine Mikrolinsen-Verteilung, in der Entwicklung eines effizienten Bauelements, beispielsweise eines effizienten LED-Strahlers, berücksichtigt und genutzt werden.

Weiterhin kann auch eine Strukturgröße Primäroptik und/oder der Sekundäroptik, beispielsweise eine Strukturgröße der Linsen der Primäroptik und/oder der Sekundäroptik, variabel angepasst werden, beispielsweise an die jeweilige Anwendung. Dabei lassen sich verschiedene Möglichkeiten realisieren, einzeln oder in beliebiger Kombination. So können die optoelektronischen Komponenten, beispielsweise die LEDs, und Komponenten der Primäroptik und/oder Sekundäroptik, beispielsweise die Linsen, vergleichbare Strukturgrößen aufweisen. Dies kann beispielsweise bedeuten, dass jede optoelektronische Komponente, beispielsweise jede LED, ein zugehöriges Element der Primäroptik und/oder der Sekundäroptik, beispielsweise eine zugehörige Linse, besitzt. Die maximale Strukturgröße der Elemente der Primäroptik bzw. der Sekundäroptik, beispielsweise die maximale Strukturgröße der jeweiligen Linse, ist dabei in der Regel durch den Pitch der optoelektronischen Komponenten, beispielsweise der LEDs, begrenzt.

Weiterhin lassen sich, alternativ oder zusätzlich, auch Ausführungsformen realisieren, bei welchem die Strukturgröße einzelner, mehrerer oder aller optoelektronischer Komponenten kleiner ist als die Strukturgröße der Optik, beispielsweise der Primäroptik. Beispielsweise lassen sich Ausführungsformen realisieren, bei welchen die Strukturgröße der LED kleiner ist als die der zugehörigen Linse. Dies kann dann beispielsweise bedeuten, dass sich eine Linse und/oder eine andere Komponente der Primäroptik und/oder der Sekundäroptik über mehrere optoelektronische Komponenten, beispielsweise über mehrere LEDs, erstreckt.

Weiterhin lassen sich, alternativ oder zusätzlich, auch Ausführungsformen realisieren, bei welchen die Strukturgröße einzelner, mehrerer oder aller optoelektronischer Komponenten größer ist als die Strukturgröße der Optik, beispielsweise der Primäroptik. Beispielsweise lassen sich Ausführungsformen realisieren, bei welchen die Strukturgröße der LED größer ist als die der Linse. Dies kann dann beispielsweise bedeuten, dass sich vor einer optoelektronischen Komponente, beispielsweise vor einer LED, mehrere Elemente der Primäroptik und/oder der Sekundäroptik, beispielsweise mehrere Linsen oder ein Linsenarray, befinden.

Weiterhin können innerhalb eines Arrays auch die Verhältnisse der Strukturgrößen der optoelektronischen Komponenten und/oder der Optik in einer oder beiden Raumrichtungen variieren. So können die Verhältnisse in beiden Raumrichtungen gleich oder unterschiedlich sein oder sich auch im Verlauf verändern.

Wie oben ausgeführt, kann die Optik streuende und/oder kollimierende und/oder fokussierende Funktionen aufweisen. So kann beispielsweise eine Linsenfunktion der Primäroptik vorgesehen sein, welche streuend, kollimierend oder fokussierend ausgelegt ist. Wird nur eine Primäroptik verwendet, so ist es in der Regel von Vorteil, wenn diese kollimierend oder fokussierend ausgelegt ist. Bei der Verwendung eines Reflektors als Sekundäroptik kann es hingegen beispielsweise zweckdienlich hinsichtlich der Effizienz und Funktionalität des Gesamtsystems sein, die Primäroptik streuend auszulegen, um so den Reflektor bestmöglich ausnutzen zu können.

Ein Abstand zwischen optoelektronischer Komponente, beispielsweise der LED, und der Primäroptik entscheidet in der Regel ebenfalls darüber, welcher Anteil des Lichts, beispielsweise des von den LEDs emittierten Lichts, durch Primäroptik, insbesondere die Linsen, beeinflusst werden kann und wie die Wirkung auf dieses Licht ist. Der Abstand kann mit darüber entscheiden, ob das Licht streuend oder kollimierend ist. Innerhalb eines Arrays kann der Abstand zwischen der optoelektronischen Komponente, beispielsweise der LED, und der Linse gleich sein oder variieren. Bei vorgegebener Linsengröße kann ein Akzeptanzwinkel, auch als Numerische Apertur NA bezeichnet, der Linse vom Abstand zur optoelektronischen Komponente, beispielsweise LED, abhängen. Licht, das außerhalb dieses Akzeptanzwinkels emittiert wird, wird an den Rändern der Linse oder den Nachbarlinsen gestreut und/oder unkontrolliert gebrochen, so dass dieses als Verlustanteil einzustufen ist. Auch aus diesem Grund kann der Abstand zwischen der optoelektronischen Komponente, beispielsweise der LED, und der Oberfläche der Primäroptik relevant sein.

Weiterhin ist auch die Größe des Raumwinkels, in dem die Primäroptik und/oder die Sekundäroptik Einfluss auf den Strahlengang des emittierten oder auftreffenden Lichts, beispielsweise des von den LEDs in den Halbraum emittierten Lichts, ausüben kann, in der Regel ein relevantes Maß für die Effizienz der Optik. Um diese Effizienz zu verbessern, sollte daher zumeist die zur Verfügung stehende optisch wirksame Grundfläche der Optik maximiert werden. Eine Maßnahme, die erfindungsgemäß umsetzbar ist, kann darin bestehen, anstelle leicht auszuformender, runder Grundflächen und rotationssymmetrischer horizontaler Schnittflächen rechteckige oder polygonale Grund- und Schnittflächen zur berücksichtigen, die die zur Verfügung stehenden Flächen zwischen benachbarten optoelektronischen Komponenten, beispielsweise zwischen benachbarten LEDs, maximal ausnutzen. Bei einem Array mit gleichem Pitch in beide Raumrichtungen entspricht dies beispielsweise einer quadratischen Grundform. Mit der maximalen Ausnutzung der beispielsweise quadratischen Grundfläche kann die optisch aktive Fläche maximiert werden, was sich in einer Erhöhung oder sogar einer Maximierung der Effizienz niederschlagen kann.

Die Oberfläche der Primäroptik kann glatt, aufgeraut oder anderweitig strukturiert sein, wobei in letzterem Fall beispielsweise die Oberfläche auch mit einer Fresneloptik versehen sein kann. Bei einer glatten Oberfläche wird beispielsweise in der Regel die eigentliche Linsenwirkung nicht beeinflusst. Bei einer gezielten Formung, beispielsweise einer Kollimierung, kann mit dieser Oberfläche in vielen Fällen die größte Effizienz zu erzielen sein. Mit einer aufgerauten und/oder mikrostrukturierten Struktur kommt in der Regel zur eigentlichen Linsenwirkung ein zusätzlicher streuender Effekt hinzu.

Werden in der Optik, beispielsweise der Primäroptik, Linsen verwendet, so können diese auf verschiedene Weisen zu den zugeordneten optoelektronischen Komponenten ausgerichtet sein. So kann beispielsweise ein Linsenmittelpunkt einer Linse der Primäroptik zentral oder dezentral zu einer zugeordneten optoelektronischen Komponente, beispielsweise zu einer LED, ausgerichtet sein. Eine Dezentrierung, beispielsweise im Mikrometer- bis Millimeter-Bereich oder größer, kann dabei gezielt für alle Linsen gleich oder auch gleitend verschoben sein. Durch derartige Verschiebungen kann ein durch die Primäroptik geformter Lichtkegel beispielsweise gekippt werden. Dadurch kann beispielsweise ein so genannter Schieleffekt zur Steigerung der Bestrahlungsstärke im Zentrum vor dem LED-Array erreicht werden, indem beispielsweise die Lichtkegel der am Rand befindlichen LEDs durch eine derartige relative Verschiebung auf die Mitte richtet. Eine statistisch verteilte relative Verschiebung innerhalb eines LED-Arrays kann aber auch zur Homogenisierung des Lichts genutzt werden.

Wie oben ausgeführt, kann mindestens eine Primäroptik mit mindestens einer Sekundäroptik kombiniert werden. Die Sekundäroptik kann beispielsweise mindestens einen Reflektor und/oder mindestens eine Linse umfassen, wobei die genannten Elemente einzeln oder auch in einem Array angeordnet sein können. So kann die Sekundäroptik beispielsweise ein Reflektor-Array und/oder ein Linsen-Array umfassen. Gerade in großen Abständen trägt in der Regel bei einem alleinigen Einsatz der Primäroptik nur das Licht eines verhältnismäßig kleinen Raumwinkelbereiches zur Beleuchtung bei. Durch die Sekundäroptik wird auch das Licht eines vergrößerten Raumwinkelbereiches nutzbar gemacht, wodurch sich die Effizienz des Gesamtsystems steigern lässt. Dadurch können zwei Effekte oder ein Mischeffekt aus beiden Effekten erzielt werden. So kann durch die Sekundäroptik eine Fokussierung des Lichts deutlich verbessert werden. Dies hat den Vorteil, dass bei gleichbleibender Anzahl der optoelektronischen Komponenten, beispielsweise bei gleichbleibender LED-Anzahl, die maximale Bestrahlungsstärke erhöht werden kann. Soll die maximale Bestrahlungsstärke auf gleichem Niveau bleiben, so kann die Anzahl der optoelektronischen Komponenten, beispielsweise die Anzahl der LEDs, verringert werden, da das vorhandene Licht durch die Sekundäroptik effizienter genutzt werden kann.

Die Primäroptik kann beispielsweise auch mit mindestens einem Reflektor und/oder mindestens einem weiteren Linsenarray als Sekundäroptik kombiniert werden. Dadurch ist es in der Regel möglich, die durch die Primäroptik erzeugte Feldverteilung weiter zu transformieren. So ist es damit beispielsweise möglich, eine verbesserte Fokussierung zu erzielen, um so die maximale Bestrahlungsstärke zu erhöhen.

Die Sekundäroptik kann je nach Anwendungsprozess auch derart ausgelegt werden, dass diese in einer oder in beiden Raumrichtungen wirkt. Konkret kann dies im Falle eines Linienstrahlers für einen Durchlaufprozess bedeuten, dass die Sekundäroptik orthogonal zur Laufrichtung angeordnet sein kann und dazu dienen kann, in Laufrichtung die Dosisleistung und die maximale Bestrahlungsstärke in der Zielfläche zu erhöhen. Beispielsweise kann die Primäroptik bei einem Flächenstrahler auch als Gitter konzipiert werden, oder bei einem Linienstrahler als parallel zueinander verlaufende Linien-(Reflektor-)profile ausgeformt werden. Dies kann bedeuten, dass die Strukturgröße der Sekundäroptik ebenfalls variabel angepasst werden kann. Dabei können mehrere Möglichkeiten realisiert werden:
a. Primär- und Sekundäroptik besitzen vergleichbare Strukturgrößen.
b. Die Strukturgröße der Primäroptik ist kleiner als die der Sekundäroptik.
c. Die Strukturgröße der Primäroptik ist größer als die der Sekundäroptik.

Innerhalb des Strahlers können die Verhältnisse der Strukturgrößen in beiden Raumrichtungen gleich oder unterschiedlich sein oder sich auch im Verlauf verändern.

Um verschiedene Prozessbereiche bedienen zu können, können jeweils in der Größe angepasste Träger, insbesondere Substrate, entworfen werden. Um Kosten und Aufwand jedoch gering zu halten, ist es in der Regel sinnvoll, identische Substrate, beispielsweise mit einer Fläche im Bereich 1 cm² oder größer, aneinander zu reihen. Daher ist ein modularer Aufbau des erfindungsgemäßen Systems, beispielsweise des LED-Systems, und des optischen Konzepts realisierbar. Auch bezüglich dieser Realisierung existieren wiederum mehrere Varianten. So kann beispielsweise eine Anreihung zweier oder mehrerer erfindungsgemäßer optoelektronischer Chip-On-Board-Module in einer Raumrichtung oder in zwei Raumrichtungen erfolgen. Ein Verguss kann für ein, zwei oder mehrere optoelektronische Chip-On-Board-Substrate oder Chip-On-Board-Module gleichzeitig realisiert werden. Der Verguss kann beispielsweise ohne seitlichen Überstand auf dem Träger, beispielsweise dem Substrat, aufgebracht werden, so dass eine lückenlose Aneinanderreihung von Trägern möglich ist.

Weiterhin können beispielsweise auch ein oder mehrere optoelektronische Chip-On-Board-Module und/oder deren Träger und/oder ein oder mehrere erfindungsgemäße Systeme auf einem oder mehreren Kühlkörpern angeordnet sein, oder ein optoelektronisches Chip-On-Board-Modul und/oder ein erfindungsgemäßes System können einen oder mehrere Kühlkörper umfassen. So können sich beispielsweise ein oder mehrere Chip-On-Board-Substrate mit LEDs auf einem Kühlkörper/Träger befinden. Im Vergussprozess kann beispielsweise mindestens ein Kühlkörper mit einem Verguss versehen werden, so dass beispielsweise alle sich darauf befindlichen Träger gleichzeitig vergossen werden können. Ein gleichzeitiger gemeinsamer Verguss mehrerer Kühlkörper, welche als Modulbasis fungieren können, ist ebenfalls denkbar.

Eine Modularität der Sekundäroptik kann dabei allgemein auch einer Modularität der optoelektronischen Komponenten, beispielsweise einer Modularität des LED Arrays, entsprechen, sodass beispielsweise ein Array optoelektronischer Komponenten, beispielsweise ein LED-Array, ein Sekundäroptikmodul enthält.

Sind Sekundäroptikmodule vorgesehen, so können diese größer oder auch kleiner sein als ein Array der optoelektronischen Komponenten, beispielsweise als ein LED-Array, so dass beispielsweise ein Sekundäroptikmodul über zwei, drei oder mehr nebeneinander angeordneten Arrays optoelektronischer Komponenten, beispielsweise LED-Arrays, positioniert werden kann. Im umgekehrten Fall können beispielsweise zwei, drei oder mehr Sekundäroptikmodule pro Array der optoelektronischen Komponenten, beispielsweise pro LED-Array, benötigt werden.

Eine optionale Aneinanderreihung von optoelektronischen Chip-On-Board-Modulen und/oder von Trägern derselben, beispielsweise in einem erfindungsgemäßen System, und/oder eine Aneinanderreihung von Sekundäroptiken kann, bezogen auf den Abstand der optoelektronischen Komponenten, pitcherhaltend, also unmittelbar anreihbar, oder auch nichtpitcherhaltend, also anreihbar mit Zwischenabstand, sein.

Innerhalb eines optoelektronischen Chip-On-Board-Moduls oder eines Systems, beispielsweise innerhalb eines LED-Strahlers, können verschieden geformte Sekundäroptiken verwendet werden. So können beispielsweise am Rande eines optoelektronischen Chip-On-Board-Moduls, insbesondere am Rand eines LED-Strahlers, Reflektoren eingesetzt werden, die das Licht beispielsweise schräg auf ein Zentrum vor den Strahler reflektieren, beispielsweise ähnlich der oben beschriebenen "schielenden" Primäroptik. Dabei können die zentralen Reflektoren das Licht ebenso auf das Zentrum vor den Strahler reflektieren.

Weiterhin können positionsabhängig unterschiedliche Sekundäroptiken eingesetzt werden, beispielsweise mindestens ein Reflektor, mindestens eine Linse oder mindestens eine Kombination aus mindestens einem Reflektor mindestens einer Linse. Alternativ können Sekundäroptiken auch positionsabhängig gänzlich entfallen.

Insgesamt lassen sich erfindungsgemäß optoelektronische Chip-On-Board-Module realisieren, die vorzugsweise mindestens eine Primäroptik aufweisen, die beispielsweise lediglich eine Austrittsseite aufweist. Reflexionsverluste an einer Eintrittsseite lassen sich auf diese Weise vermeiden. Weiterhin kann eine Formgebung, beispielsweise eine Verwendung einer optischen Form einer Linse erfolgen, welche Reflexionsverluste verringern kann. Für jede einzelne optoelektronische Komponente, beispielsweise für jede einzelne LED, kann eine den Zielvorgaben angepasste Strahlformung generiert werden. Durch die Möglichkeit einer räumlichen Nähe der Optik zu den optoelektronischen Komponenten, beispielsweise der Linsen zu den LEDs, ist das Licht eines großen Raumwinkelbereiches nutzbar.

Weiterhin können die optoelektronischen Komponenten, beispielsweise die LEDs; einen schützenden, transparenten, UV- und temperaturstabilen Verguss erhalten. Auf diese Weise lässt sich insbesondere auch eine Langzeitstabilität verbessern, und aufgrund einer erhöhten Dichtigkeit gegenüber Feuchtigkeit und anderen Umwelteinflüssen lassen sich neue Einsatzgebiete erschließen.

Durch die Möglichkeit eines variabel einstellbaren Abstands zwischen den optoelektronischen Komponenten, beispielsweise zwischen den LEDs, in einer oder beiden Raumrichtungen kann die zur Verfügung stehende Lichtleistung weiterhin genau an die jeweiligen Erfordernisse angepasst werden. Beispielsweise lassen sich viele LEDs auf engem Raum anordnen, oder es lassen sich vergleichsweise weniger LEDs anordnen, um Platz für eine bestimmte Optik zu generieren.

Durch die verschiedenen möglichen Strukturgrößen der Elemente der Primäroptik, beispielsweise der Linsen der Primäroptik, kann die vorhandene Lichtleistung effizient genutzt werden. So kann eine Linsenfunktion der Primäroptik beispielsweise je nach Bedarf streuend, kollimierend oder fokussierend ausgelegt werden. Die Oberfläche der Primäroptik kann je nach Bedarf beispielsweise glatt, aufgeraut oder anderweitig strukturiert ausgestaltet werden.

Durch die Möglichkeit einer Verschiebung der Elemente der Primäroptik relativ zu den zugeordneten optoelektronischen Komponenten, beispielsweise durch eine Verschiebung der Linse der Primäroptik relativ zur LED, kann, wie oben beschrieben, ein Strahlkegel geneigt werden (Schielen).

Durch den Einsatz einer oder mehrerer optionaler Sekundäroptiken kann die Effizienz des optoelektronischen Chip-On-Board-Moduls und/oder die Effizienz des Systems deutlich erhöht werden. Insbesondere lässt sich auf diese Weise ein "Recycling" von divergentem Licht realisieren. Dadurch können beispielsweise höhere Bestrahlungsstärken erzielt werden, und/oder es lassen sich optoelektronische Komponenten, insbesondere LEDs, einsparen.

Ein weiterer Vorteil der vorliegenden Erfindung besteht in der Möglichkeit einer Realisierung einer hohen Modularität. So lassen sich beispielsweise optoelektronische Chip-On-Board-Module mit jeweils einem oder mehreren ein- oder zweidimensionalen Arrays optoelektronischer Komponenten realisieren, wobei diese Arrays identisch ausgestaltet werden können. Mehrere derartiger optoelektronischer Chip-On-Board-Module, insbesondere mit identischen Arrays der optoelektronischen Komponenten, können in ein oder zwei Raumrichtungen aneinander angereiht werden. Die Identität der Arrays der optoelektronischen Komponenten, beispielsweise der LED-Arrays, kann von Vorteil sein für einen einfachen und kosteneffizienten Produktionsablauf. Insgesamt lassen sich auf diese Weise Vorteile hinsichtlich einer Anpassung an verschiedene Prozessgeometrien realisieren.

Diese einzelnen, erfindungsgemäß realisierbaren Vorteile oder auch Kombinationen dieser Vorteile können eine direkte Effizienzsteigerung des optoelektronischen Chip-On-Board-Moduls und/oder des Systems, beispielsweise des Strahlers, bewirken. Dadurch können beispielsweise sehr hohe Bestrahlungsstärken bei gleichzeitig homogenen Bestrahlungsstärkeverteilungen auch noch in großen Abständen erreicht werden. Die aufgelisteten Vorteile können paarweise oder in beliebigen Gruppen auch beliebig miteinander kombiniert werden. Das Spektrum der zu realisierenden Möglichkeiten ist dadurch hoch, wodurch eine Vielzahl von Ansprüchen erfüllt werden können.

Die Erfindung wird nachstehend ohne Beschränkung des allgemeinen Erfindungsgedankens anhand von Ausführungsbeispielen unter Bezugnahme auf die Zeichnungen beschrieben, wobei bezüglich aller im Text nicht näher erläuterten erfindungsgemäßen Einzelheiten ausdrücklich auf die Zeichnungen verwiesen wird. Es zeigen:
- Fig. 1: eine schematische Darstellung von zwei Chip-On-Board-LED-Modulen,
- Fig. 2: eine schematische Darstellung eines erfindungsgemäßen Chip-On-Board-LED-Moduls,
- Fig. 3a), 3b): eine schematische Darstellung des erfindungsgemäßen Verfahrens,
- Fig. 4: eine schematische Darstellung eines weiteren erfindungsgemäßen Chip-On-Board-LED-Moduls,
- Fig. 5: eine schematische Darstellung eines weiteren erfindungsgemäßen Chip-On-Board-LED-Moduls,
- Fig. 6: eine schematische Darstellung eines weiteren Chip-On-Board-LED-Moduls,
- Figuren 7A und 7B:: Ausführungsbeispiele erfindungsgemäßer Chip-On-Board-Module mit verschiedenen Primäroptiken;
- Figuren 8A und 8B:: weitere Ausführungsbeispiele erfindungsgemäß realisierbarer Chip-On-Board-Module mit unterschiedlichen Arten von Primäroptiken für mehrere optoelektronische Komponenten;
- Figur 9:: ein weiteres Ausführungsbeispiel eines Chip-On-Board-Moduls mit einer Primäroptik mit mehreren Linsen pro optoelektronischer Komponente,
- Figuren 10A und 10B:: Ausführungsbeispiele von Chip-On-Board-Modulen mit ausgerichteter Primäroptik (Figur 10A) und versetzt angeordneter Primäroptik (Figur 10B),
- Figur 11:: ein Ausführungsbeispiel eines erfindungsgemäß realisierbaren Chip-On-Board-Moduls mit Primäroptik und Sekundäroptik,
- Figur 12:: ein zu Figur 11 alternatives Ausführungsbeispiel mit Primäroptik und Sekundäroptik,
- Figur 13:: eine Darstellung des Lichtwegs in dem Ausführungsbeispiel gemäß Figur 11,
- Figur 14:: ein Ausführungsbeispiel eines Chip-On-Board-Moduls mit mehreren Sekundäroptiken, und
- Figuren 15A bis 15C:: verschiedene Ausgestaltungen erfindungsgemäßer optoelektronischer Module mit unterschiedlicher Oberflächenstruktur.

In den folgenden Figuren sind jeweils gleiche oder gleichartige Elemente bzw. entsprechende Teile mit denselben Bezugsziffern versehen, so dass von einer entsprechenden erneuten Vorstellung abgesehen wird.

Die Erfindung wird anhand von Chip-On-Board-LED-Modulen, also anhand von Leuchtkörpern, als Beispiel für optoelektronische Chip-On-Board-Module erläutert. Im Rahmen der Erfindung können anstatt von LED-Modulen als optoelektronische Komponenten auch Photodioden in Solarzellen oder andere Komponenten Anwendung finden.

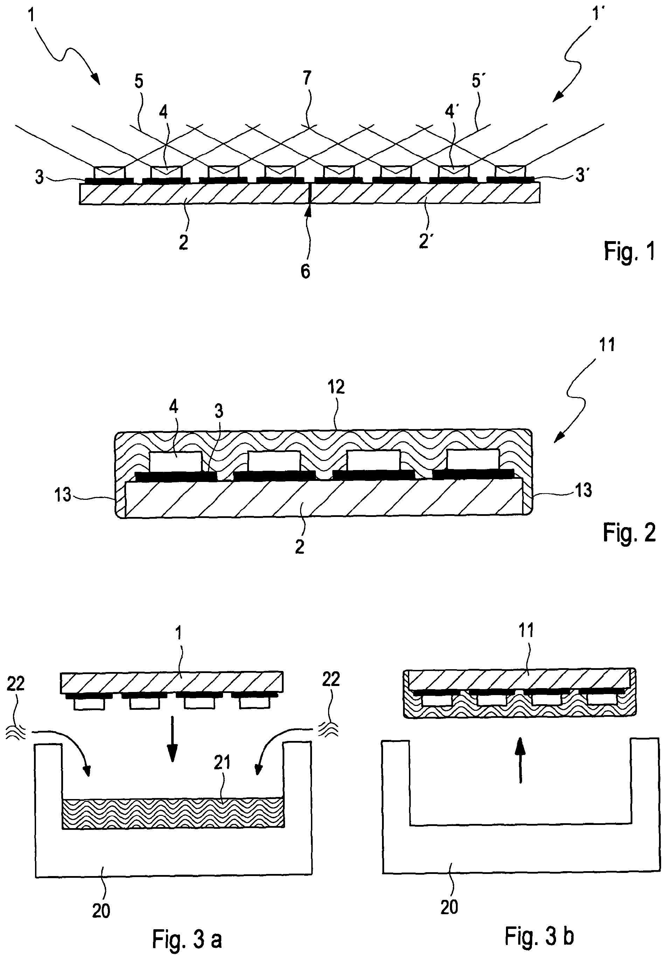

In Fig. 1 ist ein Chip-On-Board-LED-Modul 1 ohne Beschichtung im Querschnitt schematisch gezeigt, bei dem auf zwei parallel angeordneten Trägern 2, 2' bzw. Substraten Leiterbahnen 3, 3' und als unbehauste LED-Chips ausgebildete LEDs 4, 4' in regelmäßigem Abstand angeordnet sind. Aus Gründen der Übersichtlichkeit sind nicht alle wiederkehrenden Elemente der Fig. 1 und der folgenden Figuren mit Bezugszeichen versehen, diese beziehen sich jedoch auf alle gleichartigen Elemente. Es ist somit in Fig. 1 jeweils nur eine LED 4, 4' für jedes der beiden Chip-On-Board-LED-Module 1, 1' mit einer Bezugsziffer versehen. Die anderen Komponenten sind jeweils gleichartig.

Ein Träger 2, 2' kann beispielsweise ein in starrer, halbflexibler oder flexibler Substrattechnologie aufgebautes Metall-, Keramik- oder Siliziumsubstrat, eine Metallkern- oder FR4-Leiterplatte, ein Glasträger oder ein Kunststoffträger sein.

Mit Linien sind Lichtkegel 5, 5' der LEDs 4, 4'dargestellt. Die LEDs sind näherungsweise Lambert'sche Strahler, die ca. 75% der gesamten abgestrahlten Lichtleistung innerhalb eines Öffnungswinkels von 120° abstrahlen. Ist die mit LEDs 4, 4' bestückte Fläche gegenüber dem Messabstand ausgedehnt und der Abstand hinreichend größer als der Abstand der LED-Chips, auch "Pitch" genannt, dann wird eine homogene Intensitätsverteilung mit ähnlichen Eigenschaften gemessen, wie die einer homogenen, diffus leuchtenden Fläche.

Im in Fig. 1 dargestellten Fall setzt sich die homogene Intensitätsverteilung auch über die Stoßstelle 6 zwischen benachbarten Modulen 1,1' fort, da der Überlappungsbereich 7 der Lichtkegel 5, 5' an dieser Stelle aufgrund der regelmäßigen und randständigen Bestückung der Träger 2, 2' mit LEDs 4, 4' und dem Fehlen von optischen Hindernissen gut ausgebildet ist.

In Fig. 2 ist ein erfindungsgemäßes Chip-On-Board-LED-Modul 11 schematisch dargestellt, das auf einem Träger 2 ebenfalls Leiterbahnen 3 und LED-Chips 4 aufweist. Es ist mit einer Silikonbeschichtung 12 versehen, die in Randbereichen 13 auch über die Seitenränder des Trägers 2 hinausreichen und den Träger 2 somit rundum schützen.

Die erfindungsgemäßen Chip-On-Board-LED-Module 2 gemäß Fig. 2 können bündig nebeneinander angeordnet werden, so dass ein gleichmäßiger überlappender Strahlungsbereich mit einer Strahlungscharakteristik wie in Fig. 1 dargestellt, erzielbar ist.

In Fig. 3a) und Fig. 3b) ist schematisch dargestellt, wie das erfindungsgemäße Chip-On-Board-LED-Modul 11 gemäß Fig. 2 hergestellt wird. Dazu wird zunächst ein unbeschichtetes Chip-On-Board-LED-Modul 1 kopfüber in eine Form 20 mit einem Bad aus flüssigem Silikon 21 eingetaucht, welches aus einem oder mehreren Silikonvorräten 22 in die Form eingefüllt worden war. Das Eintauchen geschieht in Richtung des zentral dargestellten Pfeils in Fig. 3a).

Die Füllhöhe des Silikons wird derart gewählt, dass der Träger 2 mit seiner Oberfläche die Oberfläche des Silikons berührt oder leicht darin eintaucht. Dafür sind die Ausmaße bzw. das lichte Innenmaß der Form derart gewählt, dass der Träger 2 des Chip-On-Board-Moduls 1 vollständig in die Form aufgenommen wird. Zwischen den Seitenwänden der Form 20 und der Außenseite des Trägers 2 befindet sich ggf. ein kleiner Spalt, in den Silikon 21 eindringen kann.

Das flüssige Silikon 21 wird anschließend ausgehärtet und dabei mit dem Modul vernetzt, beispielsweise thermisch. Wenn das Silikon vollständig ausgehärtet ist, wird der Träger als neu beschichtetes Chip-On-Board-LED-Modul 11 inklusive des nun gehärteten, anhaftenden und transparenten Vergusses aus der Form entnommen. Dies ist in Fig. 3b) mit dem darin zentral gezeigten Pfeil dargestellt.

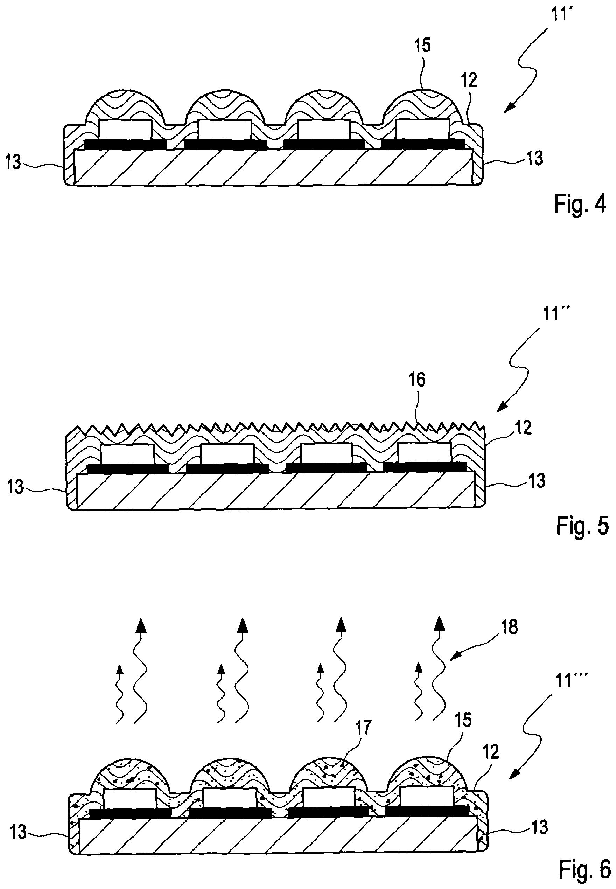

In den Figuren 4, 5 und 6 sind drei verschiedene Varianten erfindungsgemäßer optoelektronischer Chip-On-Board-Module 11', 11", 11'" dargestellt, die sich in den Komponenten des Trägers, der Leiterbahn und der LEDs nicht von dem Chip-On-Board-LED-Modul 11 aus Fig. 2 unterscheiden.

In Fig. 4 weist die Oberfläche der Beschichtung 12 eine Oberflächenstruktur in Form von Linsen, insbesondere Mikrolinsen, aus Silikon über den einzelnen LEDs auf, die aus einer inversen Abformung der Struktur aus der Form, in die zunächst das Silikon eingeführt worden war, resultiert. Diese Linsen wirken für das von den LEDs ausgesendete Licht bündelnd oder zerstreuend, je nach eingestellter Geometrie.

Die in Fig. 4 gezeigte Struktur kann auch von Photovoltaik-Modulen eingesetzt werden, um einfallendes Licht auf die entsprechenden Photodioden zu bündeln.

In Fig. 5 ist bei dem optoelektronischen Chip-On-Board-LED-Modul 11" die Oberfläche so verändert, dass sich eine aufgeraute Oberflächenstruktur 16 ergibt. Hierdurch wird das von den LEDs ausgesendete Licht in verschiedene Richtungen gestreut und die Lichtverteilung insgesamt homogenisiert.

In Fig. 6 ist bei einem erfindungsgemäßen Chip-On-Board-LED-Modul 11''' eine Oberflächenstruktur der Beschichtung 12 eingestellt, die der aus Fig. 4 mit einzelnen Linsen 15 über den LED-Chips entspricht. Zusätzlich ist die Silikonmasse mit phosphoreszierendem Material 17 versetzt, die eine Wellenlängenverschiebung des ausgesendeten Lichts bzw. eines Teils des ausgesendeten Lichts bewirkt, was durch die oberhalb der Linsen 15 dargestellten geschlängelten Pfeile mit unterschiedlichen Wellenlängen dargestellt ist. Diese Pfeile symbolisieren Photonen unterschiedlicher Wellenlängen und somit verschiedener Farben. Beispielsweise können die kleinen geschlängelten Pfeile Photonen aus dem ultravioletten Bereich entsprechen, während die größeren Pfeile Photonen im sichtbaren Bereich entsprechen können.

Alle genannten Merkmale, auch die den Zeichnungen allein zu entnehmenden sowie auch einzelne Merkmale, die in Kombination mit anderen Merkmalen offenbart sind, werden allein und in Kombination als erfindungswesentlich angesehen. Erfindungsgemäße Ausführungsformen können durch einzelne Merkmale oder eine Kombination mehrerer Merkmale erfüllt sein.

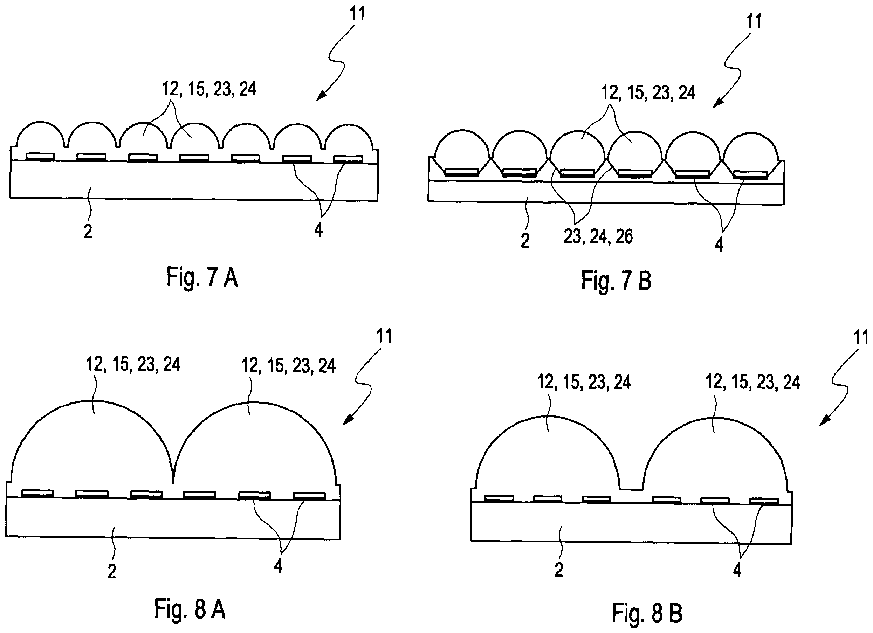

In den Figuren 7A bis 15C sind verschiedene weitere Ausgestaltungen erfindungsgemäßer Chip-On-Board-Module dargestellt, welche ohne Beschränkung weiterer möglicher Ausgestaltungen in diesen Figuren mit der Bezugsziffer 11 bezeichnet sind. Für den Aufbau und die Herstellung dieser Chip-On-Board-Module 11 kann exemplarisch auf die obige Beschreibung verwiesen werden.

So können die Chip-On-Board-Module 11, wie oben dargestellt, eine oder mehrere Optiken aufweisen, welche im Folgenden allgemein mit der Bezugsziffer 23 bezeichnet werden. Die oben erwähnten Linsen 15 stellen Beispiele derartiger Optiken 23 dar. Alternativ oder zusätzlich zu Linsen können jedoch auch andere Optiken eingesetzt werden, beispielsweise Reflektoren. Dabei wird im Folgenden allgemein zwischen einer Primäroptik 24 und einer Sekundäroptik 25 unterschieden. Wie oben ausgeführt, wird unter einer Primäroptik 24 ein optisches Element verstanden, welches auf einem Lichtweg den optoelektronischen Komponenten, in den dargestellten Ausführungsbeispielen exemplarisch den LEDs 4, benachbart gelegen ist, so dass zwischen der Primäroptik 24 und den optoelektronischen Komponenten, insbesondere den LEDs 4, keine weiteren optischen Komponenten mit streuenden, sammelnden oder kollimierenden Eigenschaften angeordnet sind. Unter einer Sekundäroptik 25 wird hingegen eine optische Komponente verstanden, welche relativ zu den optoelektronischen Komponenten, hier den LEDs 4, derart angeordnet ist, dass auf einem Lichtweg zwischen diesen Elementen und den optoelektronischen Komponenten mindestens ein weiteres optoelektronisches Element mit streuenden, sammelnden oder kollimierenden Eigenschaften angeordnet ist. Dabei können die Primäroptik 24 und/oder die Sekundäroptik 25 mittels des erfindungsgemäßen Verfahrens erfindungsgemäß ausgestaltet werden. Die Primäroptik 24 und/oder die Sekundäroptik 25 können jeweils eine oder mehrere optische Komponenten umfassen, wie beispielsweise Linsen und/oder Reflektoren.

In den Figuren 7A und 7B sind Ausführungsbeispiele von optoelektronischen Chip-On-Board-Modulen 11 dargestellt, welche jeweils ausschließlich Primäroptiken 24 umfassen. Dabei zeigt Figur 7A ein Ausführungsbeispiel, bei welchem in einem Array von LEDs 4 jeweils einer LED eine Linse 15 zugeordnet ist. Die LEDs 4 und die jeweils zugeordneten Linsen 15 der Primäroptik 24 besitzen dabei vergleichbare Strukturgrößen.

In Figur 7B ist hingegen ein Ausführungsbeispiel gezeigt, bei welchem die Primäroptik 24, zusätzlich zu Linsen 15, Reflektoren 26 umfasst. Beispielsweise können diese Reflektoren 26 als Mikroreflektoren ausgestaltet sein. Beispielsweise können die Reflektoren 26 jeweils als Vertiefungen ausgestaltet werden, beispielsweise als Vertiefungen in dem Träger 2, wobei die Oberflächen dieser Vertiefungen reflektive Eigenschaften aufweisen können. Wiederum kann beispielsweise eine Strukturgröße der Reflektoren 26 und/oder der Linsen 15 in dem in Figur 7B dargestellten Ausführungsbeispiel vergleichbar mit der Größe der Chips der LEDs 4 sein.

In den Figuren 8A und 8B sind weitere Ausführungsbeispiele von optoelektronischen Chip-On-Board-Modulen 11 gezeigt, welche jeweils eine Primäroptik 24 aufweisen. In diesem Ausführungsbeispiel weist die Primäroptik 24 jeweils wiederum Linsen 15 auf, analog zu dem Ausführungsbeispiel gemäß Figur 7A. Hierbei ist jedoch jeweils eine Linse 15 mehreren LEDs 4 zugeordnet. Die Strukturgröße der LEDs 4 ist somit kleiner als die Strukturgröße der jeweils zugeordneten Linse 15 der Primäroptik 24. Dabei ist in Figur 8A eine Ausführungsform mit konstantem Pitch (Abstand zwischen den Mitten benachbarter LEDs 4) gezeigt, also eine so genannte Pitch-erhaltende Variante, und in Figur 8B ein Ausführungsbeispiel, bei welchem unterschiedliche Pitches auftreten, also eine Pitch-variierende Variante.

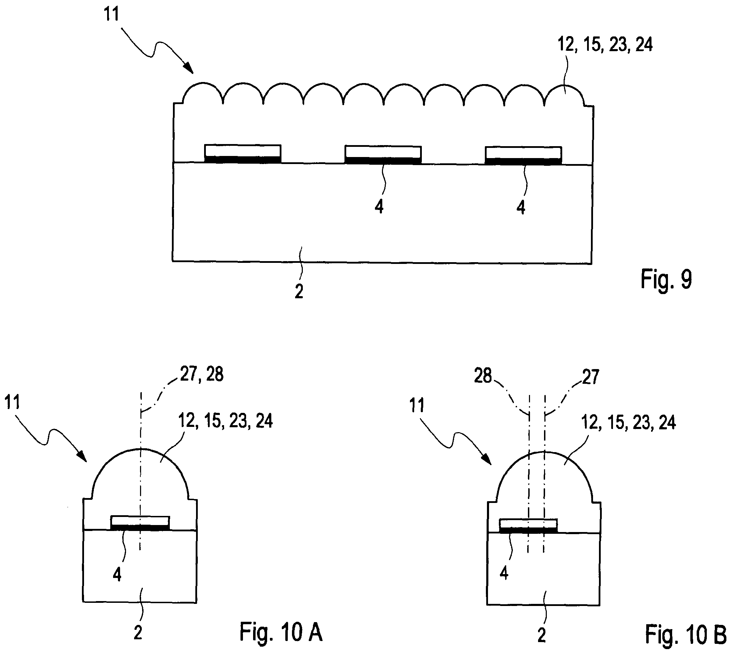

In Figur 9 ist wiederum eine Abwandlung des Ausführungsbeispiels gemäß Figur 7A gezeigt. Wiederum ist eine Primäroptik 24 vorgesehen, welche eine Mehrzahl von Linsen 15 umfasst. In dem dargestellten Ausführungsbeispiel ist jedoch jeder LED 4 eine Mehrzahl von Linsen 15 zugeordnet. Die Strukturgröße der LEDs 4 ist somit größer als die Strukturgröße der Linsen 15 der Primäroptik 24.

In den Figuren 10A und 10B sind verschiedene Ausführungsbeispiele optoelektronischer Chip-On-Board-Module 11 oder von Ausschnitten derartiger Chip-On-Board-Module 11 gezeigt, welche sich hinsichtlich einer Anordnung der Primäroptik 24 relativ zu den LEDs 4 unterscheiden. Grundsätzlich können die Ausführungsbeispiele beispielsweise ansonsten dem Ausführungsbeispiel gemäß Figur 7A entsprechen.

So zeigt Figur 10A ein Ausführungsbeispiel, bei welchem eine optische Achse 27 einer Linse 15 und eine optische Achse 28 einer LED 4 zusammen fallen, so dass, in einer Draufsicht auf das Chip-On-Board-Modul 11, ein Linsenmittelpunkt und ein Mittelpunkt der LED 4 übereinander liegen können. In Figur 10B ist hingegen ein Ausführungsbeispiel gezeigt, bei welchem die optische Achse 27 der Linse und die optische Achse 28 der LED 4 gegeneinander verschoben sind. Auch eine andere Ausgestaltung ist möglich, beispielsweise eine verkippte Ausgestaltung der Achsen 27, 28.

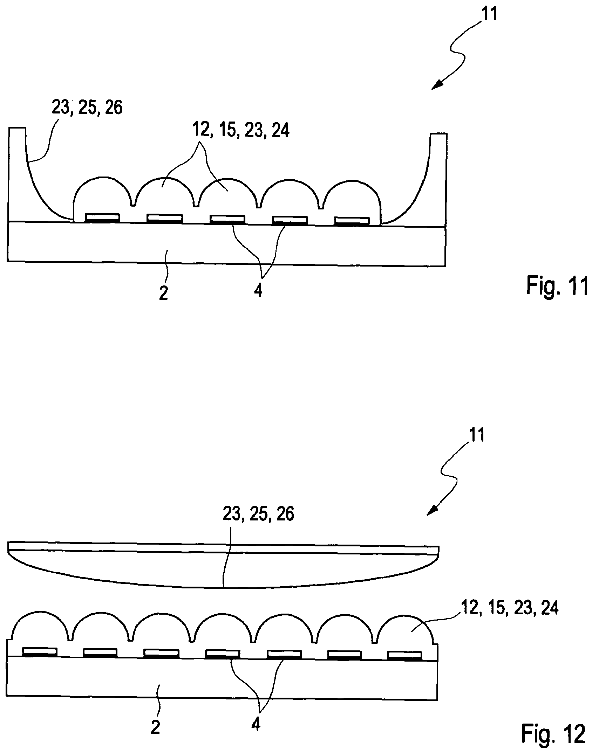

In Figur 11 ist ein Ausführungsbeispiel gezeigt, bei welchem die Optik 23 neben einer Primäroptik 24 weiterhin eine Sekundäroptik 25 aufweist. Diese Sekundäroptik 25 kann wiederum eine oder mehrere Linsen oder, wie in Figur 11 dargestellt, einen oder mehrere Reflektoren 26 umfassen. Beispielsweise kann das Ausführungsbeispiel gemäß einer oder mehreren der Figuren 7A bis 10B kombiniert werden mit einem oder mehreren Reflektoren. Dabei können eines oder mehrere der Elemente der Sekundäroptik 25 einer, mehreren oder allen LEDs 4 zugeordnet sein.

In Figur 12 ist eine Abwandlung des Ausführungsbeispiels gemäß Figur 11 gezeigt. Anstelle eines Reflektors, wie in Figur 11 dargestellt, zeigt dieses Ausführungsbeispiel, dass die Sekundäroptik, alternativ oder zusätzlich, auch eine oder mehrere Linsen umfassen kann.

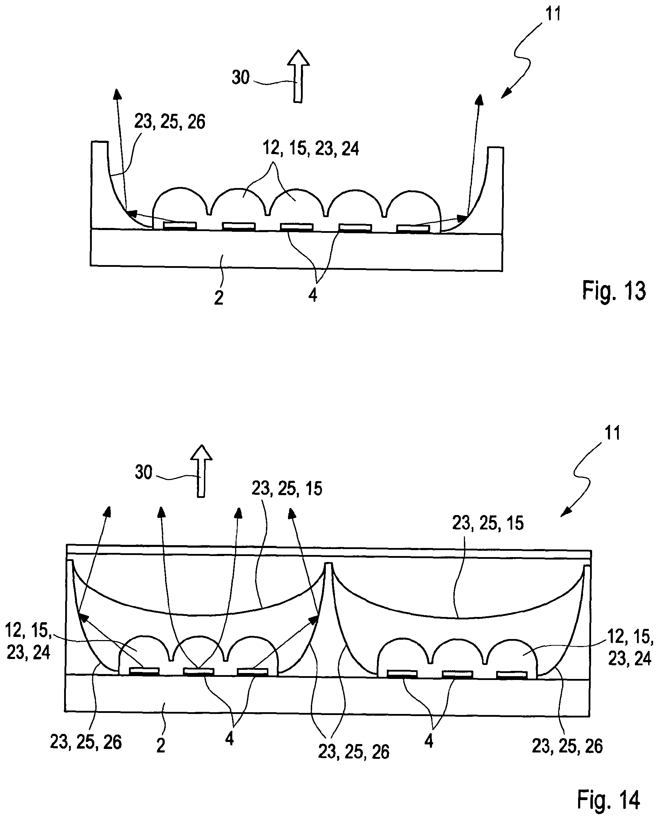

In Figur 13 ist exemplarisch ein Strahlengang innerhalb des Ausführungsbeispiels gemäß Figur 11 gezeigt. Aus einer LED 4 austretendes Licht passiert zunächst die gekrümmte Oberfläche der dieser LED 4 zugeordneten Linse 15 der Primäroptik 24, an welcher eine Brechung stattfindet, so dass diese Oberfläche als eigentliches optisches Element der Primäroptik 24 wirkt. Anschließend wird das aus der Primäroptik 24 austretende Licht teilweise an der Sekundäroptik 25 gebrochen und/oder gesammelt und/oder kollimiert. Im dargestellten Ausführungsbeispiel, in welchem ein exemplarischer Strahlengang gezeigt ist, werden die durch die Primäroptik 24 austretenden Strahlen an den Oberflächen des Reflektors 26 der Sekundäroptik 25 gespiegelt in Richtung einer Abstrahlrichtung 30, so dass ein nutzbarer Raumwinkelbereich vergrößert werden kann.

In Figur 14 ist ein Ausführungsbeispiel gezeigt, welches wiederum eine Kombination mindestens einer Primäroptik 24 und mindestens einer Sekundäroptik 25 beinhaltet. In diesem Ausführungsbeispiel umfasst die Sekundäroptik 25 jedoch mehrere Elemente, nämlich jeweils mindestens einen Reflektor 26 und mindestens eine Linse 15. Während bei der Primäroptik 24 jeweils einer LED 4 eine Linse 15 zugeordnet ist, zeigt dieses Ausführungsbeispiel exemplarisch, dass einer Gruppe von LEDs, in diesem Fall jeweils 3 LEDs oder mehr LEDs, eine gemeinsame Sekundäroptik 25 zugeordnet sein kann, wie beispielsweise ein gemeinsamer Reflektor 26 und/oder eine gemeinsame Linse 15. Wiederum sind exemplarisch verschiedene Strahlengänge angedeutet. Dabei können mehrere Einheiten mit einer gemeinsamen Sekundäroptik 25 aneinandergereiht sein in einer oder zwei Raumrichtungen, wie in Figur 14 ebenfalls exemplarisch gezeigt.

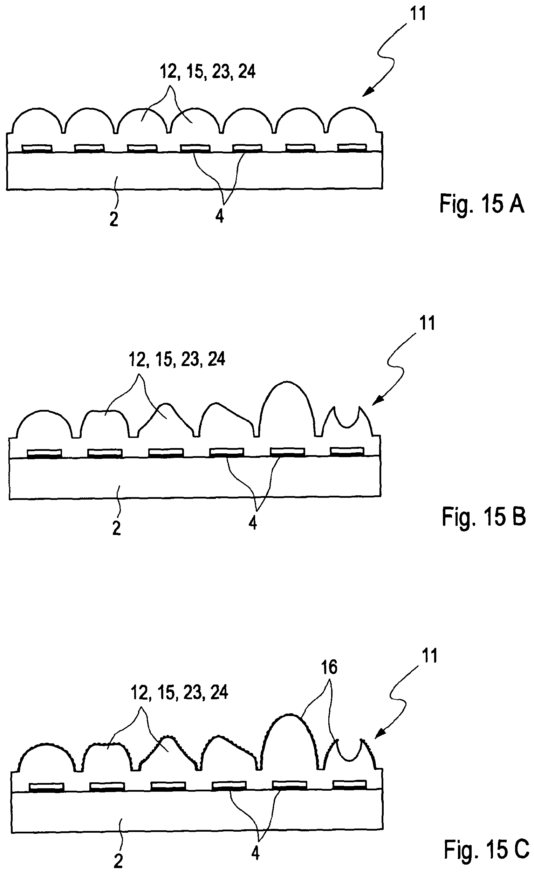

In den Figuren 15A und 15C sind verschiedene Ausführungsbeispiele gezeigt, die unterschiedliche Möglichkeiten einer Realisierung einer Oberfläche der Optik 23, insbesondere der Silikonbeschichtung 12, zeigen. In den Ausführungsbeispielen sind Beispiele für die Realisierung einer Oberflächenstruktur der Primäroptik 24 gezeigt. Alternativ oder zusätzlich können mit dem erfindungsbemäßen Verfahren jedoch auch Oberflächenstrukturen einer oder mehrerer optionaler Sekundäroptiken 25 gestaltet werden.

So ist in Figur 15A ein Ausführungsbeispiel dargestellt, welches im Wesentlichen dem Ausführungsbeispiel gemäß Figur 7A entsprechen kann. In diesem Fall ist eine glatte Oberflächenstruktur der Linsen 15 vorgesehen. Die Linsen 15 können eine sphärische Optik aufweisen.

Während in dem Ausführungsbeispiel gemäß Figur 15A exemplarisch identische Elemente der Primäroptik 24, insbesondere identische Linsen dargestellt sind, können die Elemente der Optik 23 innerhalb des optoelektronischen Moduls 11 auch variieren. Dies ist exemplarisch in Figur 15B gezeigt. In diesem Ausführungsbeispiel umfasst die Optik 23 eine Mehrzahl optischer Elemente, in diesem Fall eine Mehrzahl von Linsen, welche unterschiedliche optische Eigenschaften haben.

In Figur 15C ist schließlich gezeigt, dass die in Figur 5 gezeigte aufgeraute Oberflächenstruktur 16 auch mit einer oder mehreren Optiken 23 kombinierbar ist. Exemplarisch ist dies in dem dargestellten Ausführungsbeispiel für eine Mehrzahl von Linsen 15 gezeigt, welche exemplarisch hier der Primäroptik 24 zuzuordnen sind und welche exemplarisch hier ausgestaltet sind analog zu dem Ausführungsbeispiel gemäß Figur 15B. Auch andere Ausgestaltungen sind jedoch grundsätzlich möglich, beispielsweise eine aufgeraute Oberflächenstruktur 16 bei dem Ausführungsbeispiel gemäß Figur 15A. Alternativ oder zusätzlich zu einer aufgerauten Oberflächenstruktur 16 lassen sich auch andere Oberflächenstrukturierungen einsetzten, beispielsweise Oberflächenstrukturierungen in Form von Fresnel-Linsen.

### Bezugszeichenliste

- 1,1': unbeschichtetes Chip-On-Board-LED-Modul
- 2,2': Träger
- 3,3': Leiterbahn
- 4,4': LED
- 5,5': Lichtkegel
- 6: Stoßstelle
- 7: Überlappungsbereich
- 11 - 11"': beschichtetes Chip-On-Board-LED-Modul
- 12: Silikonbeschichtung
- 13: Beschichtung der Trägerseitenflächen
- 15: Linse aus Silikon
- 16: aufgeraute Oberflächenstruktur
- 17: phosphoreszierendes Material
- 18: Licht verschiedener Wellenlängen
- 20: Gießform
- 21: flüssiges Silikon
- 22: Silikonvorrat
- 23: Optik
- 24: Primäroptik
- 25: Sekundäroptik
- 26: Reflektor
- 27: optische Achse Linse
- 28: optische Achse LED
- 30: Abstrahlrichtung

## Patentansprüche

1. Verfahren zur Beschichtung eines optoelektronischen Chip-On-Board-Moduls (1, 11 - 11'''), das einen flächigen Träger (2, 2') umfasst, der mit einem oder mehreren optoelektronischen Komponenten (4) bestückt ist, mit einer transparenten, UV- und temperaturbeständigen Beschichtung (12) aus einem Silikon, **gekennzeichnet durch** die folgenden Verfahrensschritte:
a) Vergießen des flüssigen Silikons (21, 22) in eine nach oben offene Form (20), die Außenmaße aufweist, die den Außenmaßen des Trägers (2, 2') entsprechen oder diese übersteigen,
b) Einführen des Trägers (2, 2') in die Form (20), wobei die optoelektronische Komponente (4) oder die optoelektronischen Komponenten (4) vollständig in das Silikon (21) eingetaucht werden und eine Oberfläche des Trägers (2, 2') das Silikon (21) vollflächig berührt oder der Träger (2, 2') wenigstens teilweise vollflächig in das Silikon (21) eintaucht,
c) Aushärten und Vernetzen des Silikons (21) mit den optoelektronischen Komponenten (4) und dem Träger (2, 2'), und
d) Entnehmen des Trägers (2, 2') mit der Beschichtung (12) aus dem ausgehärteten Silikon (21) aus der Form (20);
**dadurch gekennzeichnet, dass** die Verfahrensschritte a) und/oder b) und/oder c) unter einem erhöhten atmosphärischen Druck ausgeführt werden, insbesondere bei einem atmosphärischen Druck zwischen 4 und 10 bar, insbesondere zwischen 5 und 7 bar.

2. Verfahren nach Anspruch 1, **dadurch gekennzeichnet, dass** in das flüssige Silikon (21, 22) optisch funktionale Materialien (17), insbesondere phosphoreszierende und/oder streuende Materialien oder Partikel, eingemischt sind oder werden.

3. Verfahren nach Anspruch 1 oder 2, **dadurch gekennzeichnet, dass** an einer Oberfläche der Beschichtung (12) eine durch die Form vorgegebene oder später hinzugefügte Oberflächenstruktur (15, 16) erzeugt wird.

4. Verfahren nach einem der Ansprüche 1 bis 3, **dadurch gekennzeichnet, dass** der Träger (2, 2') bis zu einem oder mehreren Rändern mit optoelektronischen Komponenten (4) bestückt ist.

5. Verfahren nach einem der Ansprüche 1 bis 4, **dadurch gekennzeichnet, dass** der Träger (2, 2') randlos und/oder bis über den Rand hinweg beschichtet wird.

6. Verfahren nach einem der vorhergehenden Ansprüche, **dadurch gekennzeichnet, dass** das Silikon (21) derart geformt wird, dass mindestens eine optische Komponente, insbesondere mindestens eine Linse (15), in dem Silikon (21) ausgebildet wird.

7. Verfahren nach einem der vorhergehenden Ansprüche, wobei das Verfahren derart durchgeführt wird, dass das Chip-On-Board-Modul (1, 11 - 11"') mindestens eine an die mindestens eine optoelektronische Komponente (4) angrenzende Primäroptik (24) und optional mindestens eine Sekundäroptik (25) aufweist, wobei mindestens eine Optik (23) ausgewählt aus der Gruppe bestehend aus der Primäroptik (24) und der Sekundäroptik (25) in dem Silikon (21) ausgebildet wird.

8. Optoelektronisches Chip-On-Board-Modul (11 - 11'''), umfassend einen flächigen Träger (2, 2'), der mit einer oder mehreren optoelektronischen Komponenten (4) bestückt ist, mit einer transparenten, UV- und temperaturbeständigen Beschichtung (12) aus einem Silikon (21, 22), **dadurch gekennzeichnet, dass** das optoelektronische Chip-On-Board-Modul (11 - 11'") nach einem Verfahren gemäß einem der vorhergehenden Ansprüche hergestellt ist, und dass eine Oberfläche des Trägers (2, 2'), die mit einer oder mehreren optoelektronischen Komponenten (4) bestückt ist, randlos mit dem Silikon (21, 22) beschichtet ist.

9. Optoelektronisches Chip-On-Board-Modul (11 - 11'") nach dem vorhergehenden Anspruch, **dadurch gekennzeichnet, dass** der Träger (2, 2') auch an seinen Seitenflächen wenigstens teilweise mit dem Silikon (21, 22) beschichtet ist.

10. Optoelektronisches Chip-On-Board-Modul (11 - 11"') nach einem der vorhergehenden, ein optoelektronisches Chip-On-Board-Modul (11 - 11"') betreffenden Ansprüche, **dadurch gekennzeichnet, dass** das Silikon (21, 22) eine Beimischung von optisch funktionalen Materialien (17), insbesondere phosphoreszierenden und/oder streuenden Materialien oder Partikeln, aufweist.

11. Optoelektronisches Chip-On-Board-Modul (11 - 11'") nach einem der vorhergehenden, ein optoelektronisches Chip-On-Board-Modul (11 - 11''') betreffenden Ansprüche, **dadurch gekennzeichnet, dass** die Beschichtung (12) eine Oberflächenstruktur (15, 16) aufweist, insbesondere Linsen (15) oder lichtstreuende Aufrauungen (16).

12. Optoelektronisches Chip-On-Board-Modul (11 - 11'") nach einem der vorhergehenden, ein optoelektronisches Chip-On-Board-Modul (11 - 11'") betreffenden Ansprüche, **dadurch gekennzeichnet, dass** die Beschichtung (12) mindestens eine optische Komponente, insbesondere mindestens eine Linse (15) und/oder mindestens einen Linsen-Array, aufweist.

13. Optoelektronisches Chip-On-Board-Modul (11 - 11'") nach einem der vorhergehenden, ein optoelektronisches Chip-On-Board-Modul (11 - 11'") betreffenden Ansprüche, **dadurch gekennzeichnet, dass** das Chip-On-Board-Modul (11 - 11'") mindestens eine an die mindestens eine optoelektronische Komponente (4) angrenzende Primäroptik (24) und optional mindestens eine Sekundäroptik (25) aufweist, wobei mindestens eine Optik (23) ausgewählt aus der Gruppe bestehend aus der Primäroptik (24) und der Sekundäroptik (25) zumindest teilweise in der Beschichtung (12) ausgebildet ist.

14. Optoelektronisches Chip-On-Board-Modul (11 - 11'") nach einem der vorhergehenden, ein optoelektronisches Chip-On-Board-Modul (11 - 11'") betreffenden Ansprüche, **dadurch gekennzeichnet, dass** der Träger (2, 2') bis an einen Rand oder bis kurz vor einem Rand mit optoelektronischen Bauteilen (4) bestückt ist.

15. System mit zwei oder mehr optoelektronischen Chip-On-Board-Modulen (11 - 11'") nach einem der vorhergehenden, ein optoelektronisches Chip-On-Board-Modul (11 - 11'") betreffenden Ansprüche, **dadurch gekennzeichnet, dass** die Träger (2, 2') der optoelektronischen Chip-On-Board-Module (11 - 11''') bündig oder mit einem definierten Abstand zueinander nebeneinander angeordnet sind, wobei sich insbesondere aufgrund einer randständigen Bestückung der Träger (2, 2') mit optoelektronischen Komponenten (4) eine auch über die Grenzen zwischen benachbarten Trägern (2, 2') hinweg regelmäßige Anordnung und Beabstandung von optoelektronischen Komponenten (4) ergibt.

## Claims

1. A method for coating an optoelectronic chip-on-board module (1, 11 - 11'''), which comprises a two-dimensional support (2, 2'), which is equipped with one or a plurality of optoelectronic components (4), comprising a transparent, UV- and temperature-resistant coating (12) of a silicon, **characterised by** the following method steps:
a) pouring the liquid silicone (21, 22) into a mould (20), which is open to the top and which has external dimensions, which correspond to the external dimensions of the support (2, 2') or exceed them,
b) inserting the support (2, 2') into the mould (20), wherein the optoelectronic component (4) or the optoelectronic components (4) are immersed completely into the silicon (21), and a surface of the support (2, 2') touches the silicon (21) holohedrally, or the support (2, 2') is immersed at least partially holohedrally into the silicon (21),
c) curing and cross-linking the silicon (21) with the optoelectronic components (4) and the support (2, 2'), and
d) removing the support (2, 2') comprising the coating (12) of the cured silicon (21) from the mould (20);
**characterised in that** the method steps a) and/or b) and/or c) are performed under an increased atmospheric pressure, in particular at an atmospheric pressure of between 4 and 10 bar, in particular between 5 and 7 bar.

2. The method according to claim 1, **characterised in that** optically functional materials (17), in particular phosphorescent and/or scattering materials or particles, are or will be mixed into the liquid silicon (21, 22).

3. The method according to claim 1 or 2, **characterised in that** a surface structure (15, 16), which is specified by the mould or which is added later, is created on a surface of the coating (12).

4. The method according to any one of claims 1 to 3, **characterised in that** the support (2, 2') is equipped with optoelectronic components (4) up to one or a plurality of edges.

5. The method according to any one of claims 1 to 4, **characterised in that** the support (2, 2') is coated without edge and/or beyond the edge.

6. The method according to any one of the preceding claims, **characterised in that** the silicon (21) is moulded in such a way that at least one optical component, in particular at least one lens (15), is embodied in the silicon (21).

7. The method according to any one of the preceding claims, wherein the method is carried out in such a way that the chip-on-board module (1, 11 - 11''') has at least one primary optical unit (24) adjoining the at least one optoelectronic component (4), and optionally at least one secondary optical unit (25), wherein at least one optical unit (23) selected from the group consisting of the primary optical unit (24) and the secondary optical unit (25) is embodied in the silicon (21).

8. An optoelectronic chip-on-board module (11 - 11'''), comprising a two-dimensional support (2, 2'), which is equipped with one or a plurality of optoelectronic components (4), comprising a transparent, UV- and temperature-resistant coating (12) of a silicon (21, 22), **characterised in that** the optoelectronic chip-on-board module (11 - 11''') is produced according to a method according to any one of the preceding claims, and that a surface of the support (2, 2'), which is equipped with one or a plurality of optoelectronic components (4), is coated with the silicon (21, 22) without edge.

9. The optoelectronic chip-on-board module (11 - 11''') according to the preceding claim, **characterised in that** the support (2, 2') is also at least partially coated with the silicon (21, 22) on its side surfaces.

10. The optoelectronic chip-on-board module (11 - 11''') according to any one of the preceding claims, which pertain to an optoelectronic chip-on-board module (11 - 11"'), **characterised in that** the silicon (21, 22) has an admixture of optically functional materials (17), in particular phosphorescent and/or scattering materials or particles.

11. The optoelectronic chip-on-board module (11 - 11'''), according to any one of the preceding claims, which pertain to an optoelectronic chip-on-board module (11 - 11"'), **characterised in that** the coating (12) has a surface structure (15, 16), in particular lenses (15) or light-scattering roughening (16).

12. The optoelectronic chip-on-board module (11 - 11'''), according to any one of the preceding claims, which pertain to an optoelectronic chip-on-board module (11 - 11'"), **characterised in that** the coating (12) has at least one optical component, in particular at least one lens (15) and/or at least one lens array.

13. The optoelectronic chip-on-board module (11 - 11'''), according to any one of the preceding claims, which pertain to an optoelectronic chip-on-board module (11 - 11'"), **characterised in that** the chip-on-board module (11 - 11'''), has at least one primary optical unit (24) adjoining the at least one optoelectronic component (4), and optionally at least one secondary optical unit (25), wherein at least one optical unit (23) selected from the group consisting of the primary optical unit (24) and the secondary optical unit (25) is at least partially embodied in the coating (12).

14. The optoelectronic chip-on-board module (11 - 11"'), according to any one of the preceding claims, which pertain to an optoelectronic chip-on-board module (11 - 11'''), **characterised in that** the support (2, 2') is equipped with optoelectronic components (4) up to an edge or to just short of an edge.

15. A system comprising two or more optoelectronic chip-on-board modules (11 - 11'''), according to any one of the preceding claims, which pertain to an optoelectronic chip-on-board module (11 - 11'"), **characterised in that** the supports (2, 2') of the optoelectronic chip-on-board modules (11 - 11'''), are arranged next to one another to be flush or at a defined distance from one another, wherein a regular arrangement and spacing of optoelectronic components (4) results in particular due to an edge-wise equipping of the supports (2, 2') with optoelectronic components (4) also beyond the boundaries between adjacent supports (2, 2')

## Revendications

1. Procédé d'enrobage d'un module de montage direct des puces opto-électronique (1, 11 à 11'''), qui comprend un support plan (2, 2') qui est équipé d'un ou plusieurs composants opto-électroniques (4), avec un enrobage transparent (12) résistant aux UV et à la température en une silicone, **caractérisé par** les étapes de procédé suivantes :
a) coulée de la silicone fluide (21, 22) dans un moule ouvert vers le haut (20) qui présente des dimensions externes qui correspondent aux dimensions externes du support (2, 2') ou dépassent celles-ci,
b) introduction du support (2, 2') dans le moule (20), dans lequel le composant opto-électronique (4) ou les composants opto-électroniques (4) sont entièrement immergés dans la silicone (21) et une surface du support (2, 2') touche la silicone (21) sur toute la surface ou le support (2, 2') s'immerge au moins partiellement sur toute la surface dans la silicone (21),
c) durcissement et réticulation de la silicone (21) avec les composants opto-électroniques (4) et le support (2, 2'), et
d) retrait du support (2, 2') avec l'enrobage (12) en la silicone durcie (21) du moule (20) ;
**caractérisé en ce que** les étapes de procédé a) et/ou b) et/ou c) sont exécutées sous une pression atmosphérique accrue, notamment à une pression atmosphérique comprise entre 4 et 10 bars, notamment entre 5 et 7 bars.

2. Procédé selon la revendication 1, **caractérisé en ce que** des matériaux fonctionnels du point de vue optique (17), notamment des matériaux ou particules phosphorescents et/ou dispersifs, sont mélangés dans la silicone fluide (21, 22).

3. Procédé selon la revendication 1 ou 2, **caractérisé en ce qu'**une structure superficielle (15, 16) prédéfinie par le moule ou ajoutée ultérieurement est générée à une surface de l'enrobage (12).

4. Procédé selon une des revendications 1 à 3, **caractérisé en ce que** le support (2, 2') est équipé de composants opto-électroniques (4) jusqu'à un ou plusieurs bords.

5. Procédé selon une des revendications 1 à 4, **caractérisé en ce que** le support (2, 2') est enrobé sans bord et/ou jusque par-dessus le bord.

6. Procédé selon une des revendications précédentes, **caractérisé en ce que** la silicone (21) est moulée de telle sorte qu'au moins un composant optique, notamment au moins une lentille (15), est réalisé dans la silicone (21).

7. Procédé selon une des revendications précédentes, **caractérisé en ce que** le procédé est réalisé de telle sorte que le module de montage direct des puces (1, 11 à 11'") présente au moins une optique primaire (24) adjacente à l'au moins un composant opto-électronique (4) et en option au moins une optique secondaire (25), dans lequel au moins une optique (23) sélectionnée parmi le groupe constitué de l'optique primaire (24) et de l'optique secondaire (25) est réalisée dans la silicone (21).

8. Module de montage direct des puces opto-électronique (11 à 11'") comprenant un support plan (2, 2') qui est équipé d'un ou plusieurs composants opto-électroniques (4), avec un enrobage transparent (12) résistant aux UV et à la température en une silicone (21, 22), **caractérisé en ce que** le module de montage direct des puces opto-électronique (11 à 11'") est fabriqué conformément à un procédé selon une des revendications précédentes, et qu'une surface du support (2, 2') qui est équipée d'un ou plusieurs composants opto-électroniques (4) est enrobée avec la silicone (21, 22) sans bord.

9. Module de montage direct des puces opto-électronique (11 à 11'''), selon la revendication précédente, **caractérisé en ce que** le support (2, 2') est au moins partiellement enrobé avec la silicone (21, 22) également sur ses faces latérales.

10. Module de montage direct des puces opto-électronique (11 à 11'''), selon une des revendications précédentes concernant un module de montage direct des puces opto-électronique (11 à 11'''), **caractérisé en ce que** la silicone (21, 22) présente un mélange de matériaux fonctionnels du point de vue optique (17), notamment de matériaux ou particules phosphorescents et/ou dispersifs.

11. Module de montage direct des puces opto-électronique (11 à 11'''), selon une des revendications précédentes concernant un module de montage direct des puces opto-électronique (11 à 11'''), **caractérisé en ce que** l'enrobage (12) présente une structure superficielle (15, 16), notamment des lentilles (15) ou grainages dispersant la lumière (16).

12. Module de montage direct des puces opto-électronique (11 à 11'''), selon une des revendications précédentes concernant un module de montage direct des puces opto-électronique (11 à 11'"), **caractérisé en ce que** l'enrobage (12) présente au moins un composant optique, notamment au moins une lentille (15) et/ou au moins un réseau de lentilles.

13. Module de montage direct des puces opto-électronique (11 à 11'''), selon une des revendications précédentes concernant un module de montage direct des puces opto-électronique (11 à 11'''), **caractérisé en ce que** le module de montage direct des puces (11 à 11'''), présente au moins une optique primaire (24) adjacente à l'au moins un composant opto-électronique (4) et en option au moins une optique secondaire (25), dans lequel au moins une optique (23) sélectionnée parmi le groupe constitué de l'optique primaire (24) et de l'optique secondaire (25) est réalisée au moins partiellement dans l'enrobage (12).

14. Module de montage direct des puces opto-électronique (11 à 11''') selon une des revendications précédentes concernant un module de montage direct des puces opto-électronique (11 à 11''), **caractérisé en ce que** le support (2, 2') est équipé de composants opto-électroniques (4) jusqu'à un bord ou jusqu'à peu avant un bord.

15. Système avec deux modules de montage direct des puces opto-électroniques (11 à 11''') ou plus selon une des revendications précédentes concernant un module de montage direct des puces opto-électronique (11 à 11'''), **caractérisé en ce que** les supports (2, 2') des modules de montage direct des puces opto-électroniques (11 à 11''') sont disposés de manière juxtaposée à fleur ou avec un écart défini les uns par rapport aux autres, dans lequel un agencement et un écartement réguliers de composants opto-électroniques (4) également par-dessus les limites entre des supports voisins (2, 2') résultent notamment en raison d'un équipement marginal des supports (2, 2') de composants opto-électroniques (4).
